# EUROPEAN PATENT APPLICATION

(11) **EP 4 775 587 A1**
(43) Date of publication of application: **15.07.2026**
(21) Application number: 24863036.0
(22) Date of filing: 05.08.2024
(51) Int. Cl.: C07F 7/08, H10K 85/40, H10K 85/60, H10K 50/12, C09K 11/06

(54) **NOVEL HETEROCYCLIC COMPOUND AND ORGANIC LIGHT-EMITTING DIODE INCLUDING SAME**

(30) Priority: 06.09.2023 KR 20230118306; 31.07.2024 KR 20240101486
(71) Applicant: SFC Co., Ltd., Cheongju-si, Chungcheongbuk-do 28122 (KR)
(72) Inventor: CHOI, Do Yeong, Cheongju-si Chungcheongbuk-do 28122 (KR); KIM, Si In, Cheongju-si Chungcheongbuk-do 28122 (KR); KIM, Kyeong Hyeon, Cheongju-si Chungcheongbuk-do 28122 (KR); JANG, Hyuk Woo, Cheongju-si Chungcheongbuk-do 28122 (KR); PARK, Seo Youn, Cheongju-si Chungcheongbuk-do 28122 (KR); CHOI, Yeon Jae, Cheongju-si Chungcheongbuk-do 28122 (KR); KIM, Kyeong Wan, Cheongju-si Chungcheongbuk-do 28122 (KR); LEE, Se Jin, Cheongju-si Chungcheongbuk-do 28122 (KR)
(74) Representative: Epping - Hermann - Fischer
(86) International application number: PCT/KR2024/011491
(87) International publication number: WO 2025/053454

(57) **Abstract**

The present invention relates to a novel aromatic heterocyclic compound that can be used in an organic light-emitting diode, and an organic light-emitting diode including same.

## Description

### Technical Field

The present disclosure relates to a novel compound that can be used in an organic light-emitting diode, and more particularly, to a novel heterocyclic compound that can be used as a host material of an emission layer in an organic light-emitting diode, thereby enabling diode characteristics of low driving voltage, high efficiency, and long lifetime, and to an organic light-emitting diode including same.

### Background Art

Organic light-emitting diodes (OLEDs), based on self-luminescence, are used to create digital displays with the advantage of having a wide viewing angle and being able to be made thinner and lighter than liquid crystal displays. In addition, an OLED display exhibits a very fast response time. Accordingly, OLEDs find applications in the full color display field or the illumination field.

In general, the term "organic light-emitting phenomenon" refers to a phenomenon in which electrical energy is converted to light energy by means of an organic material. An organic light-emitting diode utilizing the organic light-emitting phenomenon has a structure usually including an anode, a cathode, and an organic material layer interposed therebetween. In this regard, the organic material layer may have, for the most part, a multilayer structure consisting of different materials, for example, a hole injection layer, a hole transport layer, an emission layer, an electron transport layer, and an electron injection layer in order to enhance the efficiency and stability of the organic light-emitting diode. In the organic light-emitting diode having such a structure, application of a voltage between the two electrodes injects a hole from the anode and an electron from the cathode to the organic layer. In the luminescent zone, the hole and the electron recombine to produce an exciton. When the exciton returns to the ground state from the excited state, the molecule of the organic layer emits light. Such an organic light-emitting diode is known to have characteristics such as self-luminescence, high luminance, high efficiency, low driving voltage, a wide viewing angle, high contrast, and high-speed response.

Materials used as organic material layers in organic light-emitting diodes may be classified, depending on their functions, into light-emitting materials and charge transport materials, such as hole injection materials, hole transport materials, electron transport materials, and electron injection materials. The light-emitting materials may be classified into polymer-type materials and low-molecular-weight materials according to molecular weight, and may also be classified into fluorescent materials derived from singlet excited states of electrons and phosphorescent materials derived from triplet excited states of electrons according to the emission mechanism.

When only a single material is used as a light-emitting material, intermolecular interactions may cause a shift of the maximum emission wavelength toward a longer wavelength and a reduction in color purity, or may cause emission quenching, thereby reducing device efficiency. Accordingly, a host-dopant system may be used as a light-emitting material in order to improve color purity and increase emission efficiency through energy transfer.

The principle thereof is that when a dopant having a smaller energy band gap than that of the host forming the emission layer is mixed in a small amount into the emission layer, excitons generated in the emission layer are transferred to the dopant, thereby emitting light with high efficiency. At this time, since the wavelength of the host shifts to the wavelength of the dopant, light of a desired wavelength can be obtained depending on the type of dopant used.

Recently, as host compounds for organic light-emitting diodes using phosphorescence in such emission layers, heterocyclic compounds containing heteroatoms such as nitrogen or oxygen have been studied. With regard to a related art, reference may be made to Korean Patent Publication No. 10-2020-0139834 A (published on December 14, 2020) that discloses an organic light-emitting diode including an aromatic heterocyclic compound having a polycyclic ring structure as a phosphorescent host.

However, despite the preparation of various types of compounds for use in emission layers of organic light-emitting diodes, including the above related art, there is still a continuous demand for the development of novel compounds applicable to organic light-emitting diodes and organic light-emitting diodes including same, which can exhibit low driving voltage, high efficiency, and long lifetime.

### Disclosure

### Technical Problem

Accordingly, an aspect of the present disclosure is to provide a novel organic compound that can be used as a phosphorescent host material in an emission layer of an organic light-emitting diode.

In addition, another aspect of the present disclosure is to provide an organic light-emitting diode (OLED) including the organic compound as a host material therein, which exhibits the characteristics of low driving voltage, high efficiency, and long lifetime.

### Technical Solution

In order to achieve the above goals, the present disclosure provides a heterocyclic compound represented by the following Chemical Formula 1:

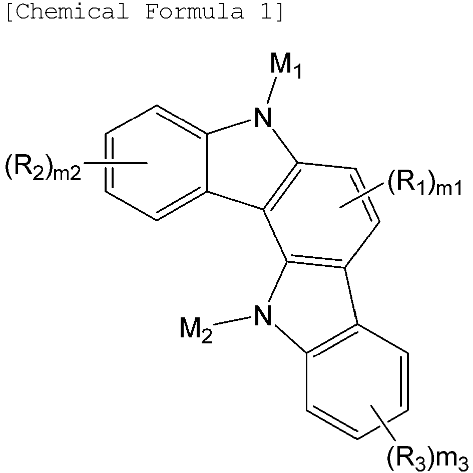

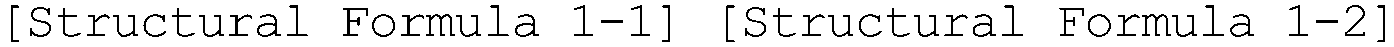

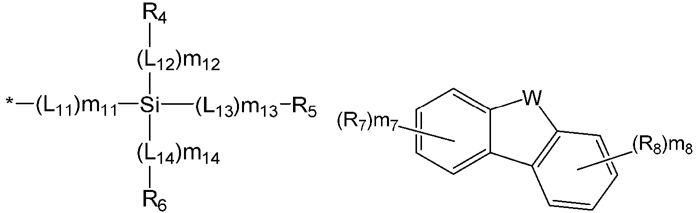

wherein,
M₁ and M₂ are each a substituent represented by Structural Formula 1-1 or Structural Formula 1-2, provided that M1 and M2 are not both represented by Structural Formula 1-1 or both represented by Structural Formula 1-2.

"*" in Structural Formula 1-1 means a bonding site to any one of the two nitrogen atoms (N) in Chemical Formula 1,
any one of the multiple substituents R₇ in Structural Formula 1-2 is a single bond to a nitrogen atom (N) other than the nitrogen atom bonded to the moiety of Structural Formula 1-1 among the two nitrogen atoms (N) of Chemical Formula 1,
the substituents R₁ to R₃, the substituent R₇ except for the single bond connected to any one of the two nitrogen atoms in Chemical Formula 1, and the substituent R₈, which are same or different, are each independently any one selected from a hydrogen atom, a deuterium atom, a tritium atom, a substituted or unsubstituted alkyl of 1 to 30 carbon atoms, a substituted or unsubstituted halogenated alkyl of 1 to 30 carbon atoms, a substituted or unsubstituted alkenyl of 2 to 30 carbon atoms, a substituted or unsubstituted alkynyl of 2 to 30 carbon atoms, a substituted or unsubstituted aryl of 6 to 50 carbon atoms, a substituted or unsubstituted cycloalkyl of 3 to 30 carbon atoms, a substituted or unsubstituted cycloalkenyl of 5 to 30 carbon atoms, a substituted or unsubstituted heterocycloalkyl of 2 to 30 carbon atoms, a substituted or unsubstituted heteroalkyl of 2 to 50 carbon atoms, a substituted or unsubstituted heteroaryl of 2 to 50 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted alkoxy of 1 to 30 carbon atoms, a substituted or unsubstituted aryloxy of 6 to 30 carbon atoms, a substituted or unsubstituted cycloalkyloxy of 3 to 30 carbon atoms, a substituted or unsubstituted heteroaryloxy of 2 to 30 carbon atoms, a substituted or unsubstituted alkylthio of 1 to 30 carbon atoms, a substituted or unsubstituted arylthio of 6 to 30 carbon atoms, a substituted or unsubstituted cycloalkylthio of 3 to 30 carbon atoms, a substituted or unsubstituted heteroarylthio of 2 to 30 carbon atoms, a substituted or unsubstituted amine of 0 to 40 carbon atoms, a substituted or unsubstituted silyl of 0 to 40 carbon atoms, a germanium of 0 to 40 carbon atoms, a nitro, a cyano, and a halogen,
the substituents R₄ to R₆, which are same or different, are each independently any one selected from a substituted or unsubstituted alkyl of 1 to 30 carbon atoms, a substituted or unsubstituted aryl of 6 to 50 carbon atoms, a substituted or unsubstituted heteroaryl of 2 to 50 carbon atoms, a substituted or unsubstituted aliphatic hydrocarbon ring-fused aryl of 8 to 30 carbon atoms, and a substituted or unsubstituted aliphatic hydrocarbon ring-fused heteroaryl of 5 to 30 carbon atoms, with exception that all of R₄ to R₆ are a substituted or unsubstituted alkyl of 1 to 30 carbon atoms,
L₁₁ to L₁₄, which are same or different, are each independently a linker selected from a single bond, a substituted or unsubstituted arylene of 6 to 18 carbon atoms, a substituted or unsubstituted heteroarylene of 3 to 18 carbon atoms, and a substituted or unsubstituted aliphatic hydrocarbon ring-fused arylene of 8 to 20 carbon atoms,
adjacent substituents in each of the multiple R₇ and the multiple R₈ may be linked to additionally form a mono- or polycyclic aliphatic or aromatic ring,
m₁ is 2, wherein the corresponding substituents R₁ are same or different,
m₂ and m₃ are each 4, wherein the corresponding substituents R₂ and the corresponding substituents R₃ are respectively same or different,
m₁₁ to m₁₄ are each 1 or 2, wherein when m₁₁ is 2, the corresponding linkers L₁₁ are same or different, when m₁₂ is 2, the corresponding linkers L₁₂ are same or different, when m₁₃ is 2, the corresponding linkers L₁₃ are same or different, and when m₁₄ is 2, the corresponding linkers L₁₄ are same or different,
m₇ and m₈ are each 4, wherein the corresponding substituents R₇ and the corresponding substituents R₈ in the respective aromatic rings are same or different,
W in Structural Formula 1-2 is O or S,
wherein the term "substituted" in the expression "a substituted or unsubstituted" used for the compounds of Chemical Formula 1 and Structural Formulas 1-1 and 1-2 means having at least one substituent selected from the group consisting of a deuterium atom, a tritium atom, a cyano, a halogen, a hydroxy, a nitro, an alkyl of 1 to 30 carbon atoms, a halogenated alkyl of 1 to 30 carbon atoms, an alkenyl of 2 to 24 carbon atoms, an alkynyl of 2 to 24 carbon atoms, a cycloalkyl of 3 to 24 carbon atoms, a heteroalkyl of 1 to 24 carbon atoms, an aryl of 6 to 24 carbon atoms, an arylalkyl of 7 to 24 carbon atoms, an alkylaryl of 7 to 24 carbon atoms, a heteroaryl of 2 to 24 carbon atoms, a heteroarylalkyl of 3 to 24 carbon atoms, an alkylheteroaryl of 3 to 24 carbon atoms, an alkoxy of 1 to 24 carbon atoms, an aromatic hydrocarbon ring-fused cycloalkyl of 7 to 30 carbon atoms, a heteroaromatic ring-fused cycloalkyl of 5 to 30 carbon atoms, an aromatic hydrocarbon ring-fused heterocycloalkyl of 6 to 30 carbon atoms, an aliphatic hydrocarbon ring-fused aryl of 7 to 30 carbon atoms, an aliphatic hydrocarbon ring-fused heteroaryl of 5 to 30 carbon atoms, a substituted or unsubstituted heteroaliphatic ring-fused aryl of 6 to 30 carbon atoms, a substituted or unsubstituted heteroaliphatic ring-fused heteroaryl of 5 to 30 carbon atoms, an amine of 1 to 30 carbon atoms, a silyl of 1 to 30 carbon atoms, a germanium of 1 to 30 carbon atoms, an aryloxy of 6 to 24 carbon atoms, and an arylthionyl of 6 to 24 carbon atoms, with at least one hydrogen atom on the substituent being substitutable with a deuterium or tritium atom.

### Advantageous Effects

When employing the heterocyclic compound represented by Chemical Formula 1 according to the present disclosure as a phosphorescent host material in an emission layer therein, an organic light-emitting diode having characteristics of lower driving voltage, higher efficiency, and longer lifetime can be provided compared to conventional organic light-emitting diodes.

### Description of Drawings

FIGURE is a schematic diagram of an organic light-emitting diode according to an embodiment of the present disclosure.

### Best Mode for Invention

Below, a detailed description will be given of the present disclosure. In each drawing of the present disclosure, sizes or scales of components may be enlarged or reduced from their actual sizes or scales for better illustration, and known components may not be depicted therein to clearly show features of the present disclosure. Therefore, the present disclosure is not limited to the drawings. When describing the principle of the embodiments of the present disclosure in detail, details of well-known functions and features may be omitted to avoid unnecessarily obscuring the presented embodiments.

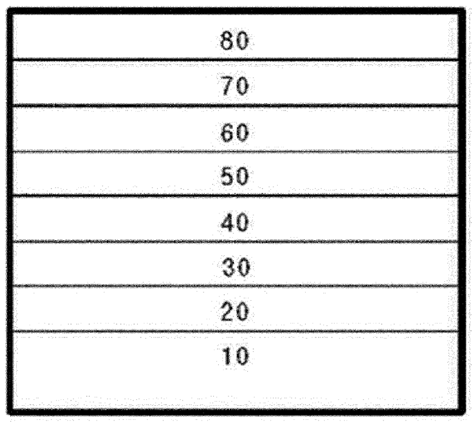

In the drawing, for convenience of description, sizes of components may be exaggerated for clarity. For example, since sizes and thicknesses of components in drawings are arbitrarily shown for convenience of description, the sizes and thicknesses are not limited thereto. Furthermore, throughout the description, the terms "on" and "over" are used to refer to the relative positioning, and mean not only that one component or layer is directly disposed on another component or layer but also that one component or layer is indirectly disposed on another component or layer with a further component or layer being interposed therebetween. Also, spatially relative terms, such as "below", "beneath", "lower", and "between" may be used herein for ease of description to refer to the relative positioning.

Throughout the specification, when a portion may "include" a certain constituent element, unless explicitly described to the contrary, it may not be construed to exclude another constituent element but may be construed to further include other constituent elements. Further, throughout the specification, the word "on" means positioning on or below the object portion, but does not essentially mean positioning on the lower side of the object portion based on a gravity direction.

The present disclosure provides a heterocyclic compound represented by the following Chemical Formula 1: 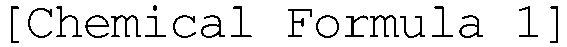 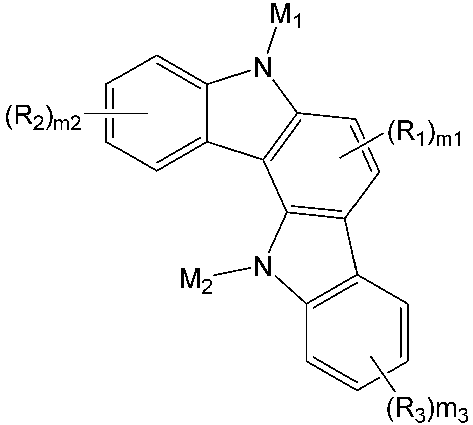 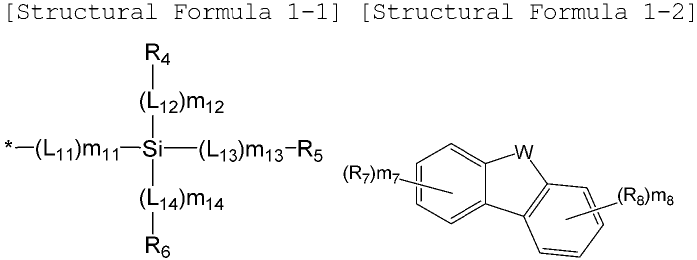 wherein,
M₁ and M₂ are each a substituent represented by Structural Formula 1-1 or Structural Formula 1-2, provided that M1 and M2 are not both represented by Structural Formula 1-1 or both represented by Structural Formula 1-2,
"*" in Structural Formula 1-1 means a bonding site to any one of the two nitrogen atoms (N) in Chemical Formula 1,
any one of the multiple substituents R₇ in Structural Formula 1-2 is a single bond to a nitrogen atom (N) other than the nitrogen atom bonded to the moiety of Structural Formula 1-1 among the two nitrogen atoms of Chemical Formula 1,
the substituents R₁ to R₃, the substituent R₇ except for the single bond connected to any one of the two nitrogen atoms in Chemical Formula 1, and the substituent R₈, which are same or different, are each independently any one selected from a hydrogen atom, a deuterium atom, a tritium atom, a substituted or unsubstituted alkyl of 1 to 30 carbon atoms, a substituted or unsubstituted halogenated alkyl of 1 to 30 carbon atoms, a substituted or unsubstituted alkenyl of 2 to 30 carbon atoms, a substituted or unsubstituted alkynyl of 2 to 30 carbon atoms, a substituted or unsubstituted aryl of 6 to 50 carbon atoms, a substituted or unsubstituted cycloalkyl of 3 to 30 carbon atoms, a substituted or unsubstituted cycloalkenyl of 5 to 30 carbon atoms, a substituted or unsubstituted heterocycloalkyl of 2 to 30 carbon atoms, a substituted or unsubstituted heteroalkyl of 2 to 50 carbon atoms, a substituted or unsubstituted heteroaryl of 2 to 50 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted alkoxy of 1 to 30 carbon atoms, a substituted or unsubstituted aryloxy of 6 to 30 carbon atoms, a substituted or unsubstituted cycloalkyloxy of 3 to 30 carbon atoms, a substituted or unsubstituted heteroaryloxy of 2 to 30 carbon atoms, a substituted or unsubstituted alkylthio of 1 to 30 carbon atoms, a substituted or unsubstituted arylthio of 6 to 30 carbon atoms, a substituted or unsubstituted cycloalkylthio of 3 to 30 carbon atoms, a substituted or unsubstituted heteroarylthio of 2 to 30 carbon atoms, a substituted or unsubstituted amine of 0 to 40 carbon atoms, a substituted or unsubstituted silyl of 0 to 40 carbon atoms, a germanium of 0 to 40 carbon atoms, a nitro, a cyano, and a halogen,
the substituents R₄ to R₆, which are same or different, are each independently any one selected from a substituted or unsubstituted alkyl of 1 to 30 carbon atoms, a substituted or unsubstituted aryl of 6 to 50 carbon atoms, a substituted or unsubstituted heteroaryl of 2 to 50 carbon atoms, a substituted or unsubstituted aliphatic hydrocarbon ring-fused aryl of 8 to 30 carbon atoms, and a substituted or unsubstituted aliphatic hydrocarbon ring-fused heteroaryl of 5 to 30 carbon atoms, with exception that all of R₄ to R₆ are a substituted or unsubstituted alkyl of 1 to 30 carbon atoms,
L₁₁ to L₁₄, which are same or different, are each independently a linker selected from a single bond, a substituted or unsubstituted arylene of 6 to 18 carbon atoms, a substituted or unsubstituted heteroarylene of 3 to 18 carbon atoms, and a substituted or unsubstituted aliphatic hydrocarbon ring-fused arylene of 8 to 20 carbon atoms,
adjacent substituents in each of the multiple R₇ and the multiple R₈ may be linked to additionally form a mono- or polycyclic aliphatic or aromatic ring,
m₁ is 2, wherein the corresponding substituents R₁ are same or different,
m₂ and m₃ are each 4, wherein the corresponding substituents R₂ and the corresponding substituents R₃ are respectively same or different,
m₁₁ to m₁₄ are each 1 or 2, wherein when m₁₁ is 2, the corresponding linkers L₁₁ are same or different, when m₁₂ is 2, the corresponding linkers L₁₂ are same or different, when m₁₃ is 2, the corresponding linkers L₁₃ are same or different, and when m₁₄ is 2, the corresponding linkers L₁₄ are same or different,
m₇ and m₈ are each 4, wherein the corresponding substituents R₇ and the corresponding substituents R₈ in the respective aromatic rings are same or different,
W in Structural Formula 1-2 is O or S,
wherein the term "substituted" in the expression "a substituted or unsubstituted" used for the compounds of Chemical Formula 1 and Structural Formulas 1-1 and 1-2 means having at least one substituent selected from the group consisting of a deuterium atom, a tritium atom, a cyano, a halogen, a hydroxy, a nitro, an alkyl of 1 to 30 carbon atoms, a halogenated alkyl of 1 to 30 carbon atoms, an alkenyl of 2 to 24 carbon atoms, an alkynyl of 2 to 24 carbon atoms, a cycloalkyl of 3 to 24 carbon atoms, a heteroalkyl of 1 to 24 carbon atoms, an aryl of 6 to 24 carbon atoms, an arylalkyl of 7 to 24 carbon atoms, an alkylaryl of 7 to 24 carbon atoms, a heteroaryl of 2 to 24 carbon atoms, a heteroarylalkyl of 3 to 24 carbon atoms, an alkylheteroaryl of 3 to 24 carbon atoms, an alkoxy of 1 to 24 carbon atoms, an aromatic hydrocarbon ring-fused cycloalkyl of 7 to 30 carbon atoms, a heteroaromatic ring-fused cycloalkyl of 5 to 30 carbon atoms, an aromatic hydrocarbon ring-fused heterocycloalkyl of 6 to 30 carbon atoms, an aliphatic hydrocarbon ring-fused aryl of 7 to 30 carbon atoms, an aliphatic hydrocarbon ring-fused heteroaryl of 5 to 30 carbon atoms, a substituted or unsubstituted heteroaliphatic ring-fused aryl of 6 to 30 carbon atoms, a substituted or unsubstituted heteroaliphatic ring-fused heteroaryl of 5 to 30 carbon atoms, an amine of 1 to 30 carbon atoms, a silyl of 1 to 30 carbon atoms, a germanium of 1 to 30 carbon atoms, an aryloxy of 6 to 24 carbon atoms, and an arylthionyl of 6 to 24 carbon atoms, with at least one hydrogen atom on the substituent being substitutable with a deuterium or tritium atom.

The expression indicating the number of carbon atoms, such as in "a substituted or unsubstituted alkyl of 1 to 30 carbon atoms", "a substituted or unsubstituted aryl of 5 to 50 carbon atoms", etc., means the total number of carbon atoms of, for example, the alkyl or aryl radical or moiety alone, exclusive of the number of carbon atoms of substituents attached thereto. For instance, a phenyl group with a butyl at the para position falls within the scope of an aryl of 6 carbon atoms, even though it is substituted with a butyl radical of 4 carbon atoms.

As used herein, the term "aryl" means an organic radical derived from an aromatic hydrocarbon by removing one hydrogen that is bonded to the aromatic hydrocarbon. When the aryl group is substituted, the substituents may be fused with one another to form an additional ring. The aryl group may also include an organic radical obtained by the removal of a single hydrogen atom from an arene ring formed by the fusion of two arene rings.

Concrete examples of the aryl include aromatic radical groups such as phenyl, o-biphenyl, m-biphenyl, p-biphenyl, o-terphenyl, m-terphenyl, p-terphenyl, naphthyl, anthryl, phenanthryl, pyrenyl, indenyl, fluorenyl, tetrahydronaphthyl, perylenyl, chrysenyl, naphthacenyl, fluoranthenyl, triphenylenyl, and the like, but are not limited thereto. The aryl group may also include organic radicals obtained by the removal of one hydrogen atom from a fused arene ring formed by two arene rings, such as a fluorene ring fused with a phenylene ring or a fluorene ring fused with a phenanthrene ring.

In addition, at least one hydrogen atom in the aryl may be substituted by a deuterium atom, a tritium atom, a halogen atom, a hydroxy, a nitro, a cyano, a silyl, an amino (-NH₂, -NH(R), -N(R') (R") wherein R' and R" are each independently an alkyl of 1 to 10 carbon atoms, in this case, called "alkylamino"), an amidino, a hydrazine, a hydrazone, a carboxyl, a sulfonic acid, a phosphoric acid, an alkyl of 1 to 24 carbon atoms, a halogenated alkyl of 1 to 24 carbon atoms, an alkenyl of 2 to 24 carbon atoms, an alkynyl of 2 to 24 carbon atoms, a heteroalkyl of 1 to 24 carbon atoms, an aryl of 6 to 24 carbon atoms, an arylalkyl of 7 to 24 carbon atoms, an alkylaryl of 7 to 24 carbon atoms, a heteroaryl of 2 to 24 carbon atoms, a heteroarylalkyl of 3 to 24 carbon atoms, or an alkylheteroaryl of 3 to 24 carbon atoms.

As used herein, the term "aromatic hydrocarbon ring" refers to an aromatic ring composed of carbon and hydrogen atoms and the term "aliphatic hydrocarbon ring" refers to a hydrocarbon ring that is composed of carbon and hydrogen atoms, but does not belong to the aromatic hydrocarbon rings. Particularly, the aliphatic hydrocarbon ring may have a bonding structure of the sp³ orbital for at least 30% of the carbon atoms as ring members, with 0 to 3 double and/or triple bonds within the ring. More particularly, the aliphatic hydrocarbon ring may have a bonding structure of the sp³ orbital for at least 50% of the carbon atoms as ring members, with 0 to 2 double and/or triple bonds within the ring.

As used herein, the term "aliphatic hydrocarbon ring-fused aryl" refers to a cyclic substituent having overall non-aromaticity, in which two adjacent carbon atoms of the aliphatic hydrocarbon ring are fused with two adjacent carbon atoms of the aryl ring, exclusive of the carbon atom that becomes an organic radical by removal of a hydrogen atom, to form a shared double bond. Specific examples include tetrahydronaphthyl, tetrahydrobenzocycloheptene, tetrahydrophenanthrenyl, tetrahydroanthracenyl, octahydrotriphenylenyl, and the like, but are not limited thereto.

The substituent "heteroaryl" used in the compound of the present disclosure refers to a cyclic aromatic system of 2 to 24 carbon atoms bearing as ring members one to three heteroatoms selected from among N, O, P, Si, S, Ge, Se, and Te. In the aromatic system, two or more rings may be fused. One or more hydrogen atoms on the heteroaryl may be substituted by the same substituents as on the aryl.

Concrete examples of the heteroaryl include thiophenyl, furanyl, pyrrolyl, imidazolyl, thiazolyl, oxazolyl, oxadiazolyl, triazolyl, pyridyl, bipyridyl, pyrimidinyl, triazinyl, acridinyl, carbolinyl, acenaphthoquinoxalinyl, indenoquinazolinyl, indenoisoquinolinyl, indenoquinolinyl, pyridoindolyl, pyridazinyl, pyrazinyl, quinolinyl, quinazolinyl, quinoxalinyl, phthalazinyl, pyridopyrimidinyl, pyridopyrazinyl, pyrazinopyrazinyl, isoquinolinyl, indolyl, carbazolyl, benzoxazolyl, benzimidazolyl, benzothiazolyl, benzocarbazolyl, benzofuranyl, benzothiophenyl, benzoselenophenyl, dibenzothiophenyl, dibenzofuranyl, dibenzoselenophenyl, phenanthrolinyl, thiazolinyl, isoxazolyl, thiadiazolyl, phenoxazinyl, phenothiazinyl, azadibenzofuranyl, azadibenzothiophenyl, azadibenzoselenophenyl, indolocarbazolyl, and the like, but are not limited thereto.

In addition, the term "heteroaromatic ring", as used herein, refers to an aromatic hydrocarbon ring bearing at least one heteroatom as an aromatic ring member. In the heteroaromatic ring, one to three carbon atoms of the aromatic hydrocarbon may be substituted by at least one selected particularly from N, O, P, Si, S, Ge, Se, and Te.

As used herein, the term "aliphatic hydrocarbon ring-fused heteroaryl" refers to the same cyclic substituent as in the aliphatic hydrocarbon ring-fused aryl, with the exception that a heteroaryl, instead of an aryl, is substituted. Specific examples include, but are not limited to, tetrahydroindole, tetrahydrobenzofuranyl, tetrahydrobenzothiophene, tetrahydrocarbazole, tetrahydrodibenzofuranyl, tetrahydroquinoline, and tetrahydroquinoxaline.

In addition, the term "heteroaromatic ring", as used herein, refers to an aromatic hydrocarbon ring bearing at least one heteroatom as an aromatic ring member. In the heteroaromatic ring, one to three carbon atoms of the aromatic hydrocarbon may be substituted by at least one selected particularly from N, O, P, Si, S, Ge, Se, and Te.

As used herein, the term "fused ring in which an aromatic hydrocarbon ring is fused with an aliphatic hydrocarbon ring" means a fused ring in which an aromatic hydrocarbon ring has two adjacent carbon atoms in common with an aliphatic hydrocarbon ring, as exemplified by a tetrahydronaphthalene ring, dihydroindene, and the like, in which the benzene ring shares two adjacent carbon atoms with the cyclohexane ring.

In the present disclosure, the term "fused ring in which a heteroaromatic hydrocarbon ring and an aliphatic hydrocarbon ring are fused to each other" refers to a cyclic radical in which two adjacent carbon atoms as ring members of an aromatic hydrocarbon ring and two adjacent carbon atoms as ring members of an aliphatic hydrocarbon ring are fused with each other to share two carbon atoms therebetween, as exemplified by hexahydrodibenzofuran in which a benzofuran ring and a cyclohexane ring are fused by sharing their respective two adjacent carbon atoms as ring members.

As used herein, the term "alkyl" refers to an alkane missing one hydrogen atom and includes linear or branched structures. Examples of the alkyl substituent useful in the present disclosure include methyl, ethyl, propyl, isopropyl, isobutyl, sec-butyl, tert-butyl, pentyl, iso-amyl, hexyl, and the like. At least one hydrogen atom of the alkyl may be substituted by the same substituent as in the aryl.

As used herein, the term "halogenated alkyl" refers to an alkyl with a halogen substituted for at least one hydrogen atom. Preferably, the halogen may be a fluorine atom.

The term "cyclo" as used in substituents of the compounds of the present disclosure, such as cycloalkyl, cycloalkoxy, etc., refers to a structure responsible for a mono- or polycyclic ring of saturated hydrocarbons within an alkyl radical, an alkoxy radical, etc. Concrete examples of cycloalkyl include cyclopropyl, cyclobutyl, cyclopentyl, cyclohexyl, methylcyclopentyl, methylcyclohexyl, ethylcyclopentyl, ethylcyclohexyl, adamantyl, dicyclopentadienyl, decahydronaphthyl, norbornyl, bornyl, isobornyl, and so on. One or more hydrogen atoms on the cycloalkyl may be substituted by the same substituents as on the aryl. This is true of the cycloalkoxy.

In the present disclosure, the term "heterocycloalkyl" refers to a cycloalkyl with at least one heteroatom substituted as a ring member for a carbon atom within the ring. Preferably, one to three carbon atoms within the ring may be substituted by at least one selected from N, O, P, S, Si, Ge, Se, and Te.

The term "aromatic hydrocarbon ring- or heteroaromatic ring-fused cycloalkyl", as used herein, refers to a cyclic radical in which two adjacent carbon atoms as ring members of an aromatic or heteroaromatic hydrocarbon ring and two adjacent carbon atoms as ring members of a cycloalkyl are fused with each other to share one double bond therebetween, with non-aromaticity across the molecule. Specific examples include tetrahydronaphthyl, tetrahydrophenanthrene, tetrahydroquinoline, tetrahydroquinoxaline, cyclopentabenzofuran, and the like, but with no limitations thereto.

The term "aromatic hydrocarbon ring-fused heterocyclic alkyl" is the same as the aromatic hydrocarbon ring-fused cycloalkyl, with the exception that at least one carbon atom within the cycloalkyl ring is substituted by a heteroatom, with non-aromaticity across the molecule. Preferably, one to three carbon atoms within the cycloalkyl ring are substituted by at least one selected from N, O, P, S, Si, Ge, Se, and Te. Specific examples of aromatic hydrocarbon ring-heterocyclic alkyl include hexahydrodibenzofuranyl, hexahydrocarbazole, hexahydrodibenzothiophene, dihydrobenzodioxine, and the like, but with no limitations thereto.

As used herein, the "heteroaliphatic ring-fused aryl or heteroaryl" is the same as the aliphatic hydrocarbon ring-fused aryl or heteroaryl, except for a heteroaliphatic ring substituted for the aliphatic hydrocarbon ring, with non-aromaticity across the molecule thereof. Specific examples include cromane, dihydropyranopyridine, thiocromane, dihydrobenzodioxine, dihydrothiopyranopyridine, dihydropyranopyrimidine, and the like, with no limitations thereto.

The term "heteroaliphatic ring" refers to an aliphatic hydrocarbon ring bearing at least one heteroatom as a ring member. Preferably, one to three carbon atoms within an aliphatic hydrocarbon are substituted by at least one heteroatom selected from N, O, and S.

The term "alkoxy," as used in the compounds of the present disclosure, refers to an alkyl or cycloalkyl singularly bonded to oxygen. Specific examples of the alkoxy include methoxy, ethoxy, propoxy, isobutoxy, sec-butoxy, pentoxy, iso-amyloxy, hexyloxy, cyclobutyloxy, cyclopentyloxy, adamantyloxy, dicyclopentyloxy, bornyloxy, isobornyloxy, and the like, but are not limited thereto. One or more hydrogen atoms on the alkoxy may be substituted by the same substituents as on the aryl.

Specific examples of the arylalkyl used in the compounds of the present disclosure include phenylmethyl (benzyl), phenylethyl, phenylpropyl, naphthylmethyl, naphthylethyl, and the like, but are not limited thereto. One or more hydrogen atoms on the arylalkyl may be substituted by the same substituents as on the aryl.

Specific examples of the alkylaryl used in the compound of the present disclosure include tolyl, xylenyl, dimethylnaphthyl, t-butylphenyl, t-butylnaphthyl, t-butylphenanthryl, and the like, but are not limited thereto. One or more hydrogen atoms on the alkylaryl may be substituted by the same substituents as on the aryl.

The term "silyl" used in the compounds of the present disclosure is intended to encompass -SiH₃, alkylsilyl, arylsilyl, alkylarylsilyl, arylheteroarylsilyl, heteroarylsilyl, and the like. The arylsilyl refers to a functional group based on -SiH₃ in which at least one of the three hydrogen atoms bonded to the silicon atom is substituted by aryl; the alkylsilyl to a functional group based on -SiH₃ in which at least one of the three hydrogen atoms bonded to the silicon atom is substituted by alkyl; the alkylarylsilyl to a functional group based on -SiH₃ in which at least two of the three hydrogen atoms bonded to the silicon atom are substituted by alkyl and aryl, respectively, as exemplified by a silyl having one or two alkyl radicals and correspondingly two or one aryl radicals;
the arylheteroarylsilyl to a functional group based on -SiH₃ in which at least two of the three hydrogen atoms bonded to the silicon atom are substituted by aryl and heteroaryl, as exemplified by a silyl having one or two aryl radicals and correspondingly two or one heteroaryl radical; and the heteroarylsilyl to a functional group based on -SiH₃ in which at least one of the three hydrogen atoms bonded to the silicon atom is substituted by heteroaryl. Examples of the arylsilyl include a substituted or unsubstituted monoarylsilyl, a substituted or unsubstituted diarylsilyl, and a substituted or unsubstituted triarylsilyl. Such examples are true of the alkylsilyl and the heteroarylsilyl.

Here, each of the aryl radicals in the arylsilyl, heteroarylsily, and arylheteroarylsilyl may be a mono- or polycyclic aryl, and each of the heteroaryl radicals in the arylsilyl, heteroarylsilyl, and arylheteroarylsilyl may be a mono- or polycyclic heteroaryl.

Furthermore, specific examples of the silyl include trimethylsilyl, triethylsilyl, triphenylsilyl, trimethoxysilyl, dimethoxyphenylsilyl, diphenylmethylsilyl, diphenylvinylsilyl, methylcyclobutylsilyl, and dimethylfurylsilyl. One or more hydrogen atoms on the silyl may be substituted by the same substituents as on the aryl.

As used herein, the term "germanium" (or germyl or germane) is intended to encompass -GeH₃, alkyl germanium, aryl germanium, heteroaryl germanium, alkylaryl germanium, alkylheteroaryl germanium, and arylheteroaryl germanium and can be accounted for by the definitions for silyl radicals, with the exception that the silicone atom (Si) in the silyl radical is substituted by a germanium atom (Ge).

Specific examples of the germanium radical include trimethylgermane, triethylgermane, triphenylgermane, trimethoxygermane, dimethoxyphenylgermane, diphenylmethylgermane, diphenylvinylgermane, methylcyclobutylgermane, and dimethylfurylgermane. One or more hydrogen atoms on the germanium radical may be substituted by the same substituents as on the aryl.

As used herein, the term "alkenyl" refers to an alkyl substituent containing a carbon-carbon double bond between two carbon atoms and the term "alkynyl" refers to an alkyl substituent containing a carbon-carbon triple bond between two carbon atoms.

As used herein, the term "alkylene" refers to an organic radical regarded as derived from an alkane by removal two hydrogen atoms from one carbon atom for methylene or different carbon atoms for ethylene or higher, such as methylene, ethylene, propylene, isopropylene, isobutylene, sec-butylene, tert-butylene, pentylene, iso-amylene, hexylene, and the like. One or more hydrogen atoms on the alkylene may be substituted by the same substituents as on the aryl.

In the present disclosure, the term "amine" is intended to encompass -NH₂, alkylamine, arylamine, alkylarylamine, arylheteroarylamine, heteroarylamine, and the like. The term "arylamine" refers to a functional group including -NH₂, in which one or two of the hydrogen atoms in - NH₂ are substituted by aryl; the term "alkylamine" to a functional group including -NH₂, in which one or two of the hydrogen atoms in -NH₂ are substituted by alkyl; the term "alkylarylamine" to a functional group including -NH₂, in which one of the hydrogen atoms in -NH₂ is substituted by alkyl and the other hydrogen atom is substituted by aryl; the term "arylheteroarylamine" to a functional group including - NH₂, in which one of the hydrogen atoms in -NH₂ is substituted by aryl and the other hydrogen atom is substituted by heteroaryl; and the term "heteroarylamine" to a functional group including -NH₂, in which one or two of the hydrogen atoms in -NH₂ are substituted by heteroaryl. Examples of the arylamine include a substituted or unsubstituted monoarylamine and a substituted or unsubstituted diarylamine. Such examples are true of the alkylamine and the heteroarylamine.

Each of the aryl radicals in the arylamine, heteroarylamine, and arylheteroarylamine may be a monocyclic or polycyclic one. Each of the heteroaryl radicals in the heteroarylamine, and arylheteroarylamine may be a mono- or polycyclic one.

In a preferable embodiment, the substituent accounted for by the term "substituted" in the expression "substituted or unsubstituted" used for compounds of Chemical Formula 1 may be at least one selected from the group consisting of a deuterium atom, a tritium atom, a cyano, a halogen, a hydroxy, a nitro, an alkyl of 1 to 12 carbon atoms, a halogenated alkyl of 1 to 12 carbon atoms, an alkenyl of 2 to 12 carbon atoms, an alkynyl of 2 to 12 carbon atoms, a cycloalkyl of 3 to 12 carbon atoms, a heteroalkyl of 1 to 12 carbon atoms, an aryl of 6 to 18 carbon atoms, an arylalkyl of 7 to 20 carbon atoms, an alkylaryl of 7 to 20 carbon atoms, a heteroaryl of 2 to 18 carbon atoms, a heteroarylalkyl of 3 to 18 carbon atoms, an alkyl heteroaryl of 3 to 18 carbon atoms, an aromatic hydrocarbon ring-fused cycloalkyl of 9 to 20 carbon atoms, a heteroaromatic ring-fused cycloalkyl of 7 to 20 carbon atoms, an aromatic hydrocarbon ring-fused heterocycloalkyl of 9 to 20 carbon atoms, an aliphatic hydrocarbon ring-fused aryl of 9 to 20 carbon atoms, an aliphatic hydrocarbon ring-fused heteroaryl of 7 to 20 carbon atoms, an alkoxy of 1 to 12 carbon atoms, an amine of 1 to 18 carbon atoms, a silyl of 1 to 18 carbon atoms, a germanium of 1 to 18 carbon atoms, an aryloxy of 6 to 18 carbon atoms, and an arylthionyl of 6 to 18 carbon atoms. At least one hydrogen atom within each substituent may be substituted with a deuterium or tritium atom.

In a more preferable embodiment of the present disclosure, the substituted or unsubstituted aromatic hydrocarbon ring-fused cycloalkyl of 7 to 30 carbon atoms may be a substituted or unsubstituted aromatic hydrocarbon ring-fused cycloalkyl of 9 to 20 carbon atoms.

In a more preferable embodiment of the present disclosure, the substituted or unsubstituted heteroaromatic ring-fused cycloalkyl of 5 to 30 carbon atoms may be a substituted or unsubstituted heteroaromatic ring-fused cycloalkyl of 7 to 20 carbon atoms.

In a more preferable embodiment of the present disclosure, the substituted or unsubstituted aromatic hydrocarbon ring-fused heterocycloalkyl of 6 to 30 carbon atoms may be a substituted or unsubstituted aromatic hydrocarbon ring-fused heterocycloalkyl of 9 to 20 carbon atoms.

In a more preferable embodiment of the present disclosure, the substituted or unsubstituted aliphatic hydrocarbon ring-fused aryl of 8 to 30 carbon atoms may be a substituted or unsubstituted aliphatic hydrocarbon ring-fused aryl of 9 to 20 carbon atoms.

In a more preferable embodiment of the present disclosure, the substituted or unsubstituted aliphatic hydrocarbon ring-fused heteroaryl of 5 to 30 carbon atoms may be a substituted or unsubstituted aliphatic hydrocarbon ring-fused heteroaryl of 7 to 20 carbon atoms.

In a more preferable embodiment of the present disclosure, the substituted or unsubstituted heteroaliphatic ring-fused aryl of 6 to 30 carbon atoms may be a substituted or unsubstituted heteroaliphatic ring-fused aryl of 7 to 20 carbon atoms.

In a more preferable embodiment of the present disclosure, the substituted or unsubstituted heteroaliphatic ring-fused heteroaryl of 5 to 30 carbon atoms may be a substituted or unsubstituted heteroaliphatic ring-fused heteroaryl of 6 to 20 carbon atoms.

As used herein, the expression "adjacent substituents among R₁ to R₃ and R₇ and R₈ except for the single bonds may be linked to each other to additionally form a mono- or polycyclic aliphatic or aromatic ring" means that one hydrogen radical is removed from each of two adjacent substituents selected from R₁ to R₈ (multiple R₁, multiple R ₂, multiple R₃, multiple R₄, multiple R₅, multiple R₆, multiple R₇, and multiple R₈), except for the single bonds, is removed and the two dehydrogenated substituents are linked to each other to additionally form a ring.

In the present disclosure, the heterocyclic compound represented by Chemical Formula 1 is technically characterized by the fused ring structure of "a six-membered aromatic hydrocarbon ring - a five-membered ring bearing a nitrogen atom - a six-membered aromatic hydrocarbon ring - a five-membered ring bearing a nitrogen atom - a six-membered aromatic hydrocarbon ring" in which the silicon atom-bearing substituent represented by Structural Formula 1-1 is bonded to any one of the two nitrogen atoms in the Chemical Formula 1 and a carbon atom within either of the aromatic ring moieties of the dibenzofuran (W=O) or dibenzothiophene (W=S) represented by Structural Formula 1-2 is directly bonded to the other nitrogen.

In an embodiment of the present disclosure, the compound represented by Chemical Formula 1 may contain at least one deuterium atom.

More specifically, at least one of the substituents R₁ to R₃ within the compound represented by Chemical Formula 1 contains a deuterium atom, at least one of the substituents R₄ to R₆ contains a deuterium atom, or the substituent R₇ (except for a single bond) or R₈ contains a deuterium atom, and more preferably, the substituents R₁ to R₃ are all deuterium atoms.

In an embodiment of the present disclosure, m₁₁ to m₁₄ within Structural Formula 1-1 are each 1, the linkers L₁₁ to L₁₄ are same or different and are each independently a single bond or a substituted or unsubstituted arylene of 6 to 12 carbon atoms.

In an embodiment of the present disclosure, the linker L₁₁ may be a single bond or a substituted or unsubstituted arylene of 6 to 12 carbon atoms.

In an embodiment of the present disclosure, the substituents R₄ to R₆ are same or different and are each independently any one selected from a substituted or unsubstituted aryl of 6 to 18 carbon atoms, a substituted or unsubstituted heteroaryl of 2 to 18 carbon atoms, and a substituted or unsubstituted aliphatic hydrocarbon ring-fused aryl of 8 to 20 carbon atoms.

In an embodiment of the present disclosure, all of the substituents R₇ to R₈ within the compound represented by Chemical Formula 1 may be deuterium atoms.

In a more preferred embodiment, the substituents R₂ and R₃ within Chemical Formula 1 are same or different and are each independently any one selected from a hydrogen atom, a deuterium atom, a substituted or unsubstituted alkyl of 1 to 10 carbon atoms, a substituted or unsubstituted aryl of 6 to 20 carbon atoms, a substituted or unsubstituted heteroaryl of 2 to 20 carbon atoms, a substituted or unsubstituted aliphatic hydrocarbon ring-fused aryl of 8 to 20 carbon atoms, and a substituted or unsubstituted amine of 1 to 30 carbon atoms.

In a more preferred embodiment, W within Structural Formula 1-2 of the heterocyclic compound represented by Chemical Formula 1 may be an oxygen atom (O).

Furthermore, concrete examples of the heterocyclic compound represented by Chemical Formula 1 in the present disclosure include, but are not limited to, the following compounds 1 and 87:

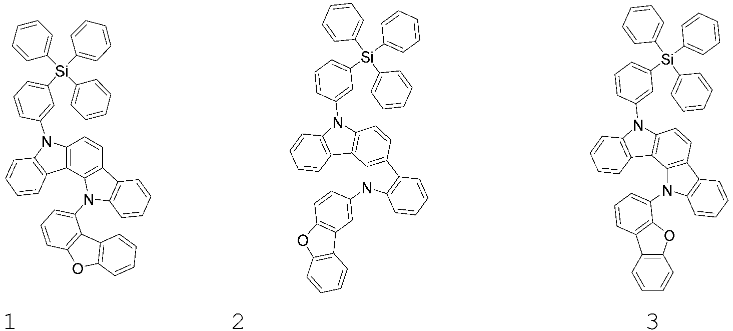

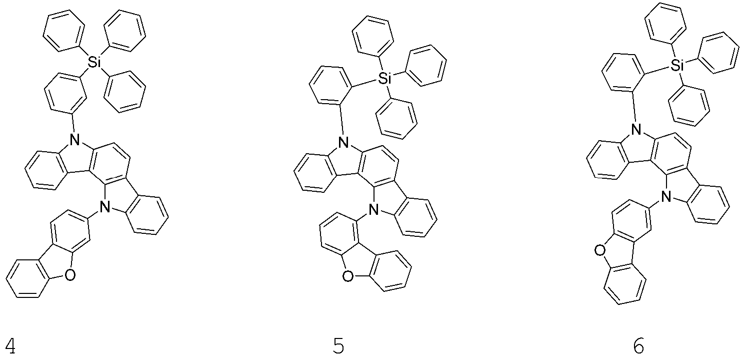

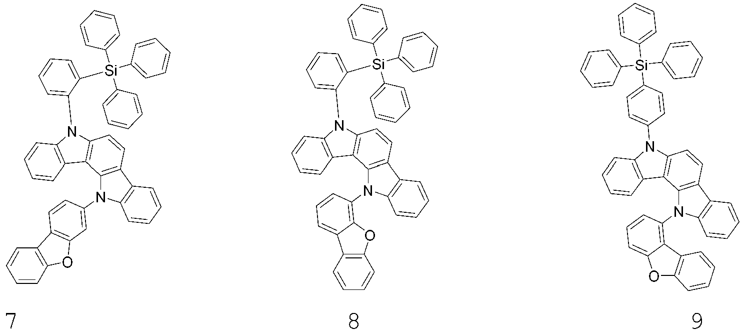

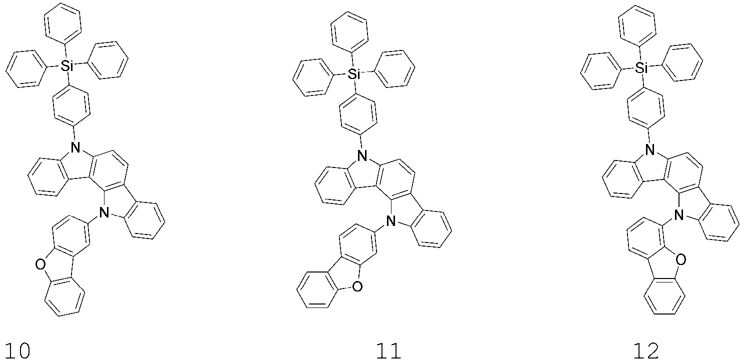

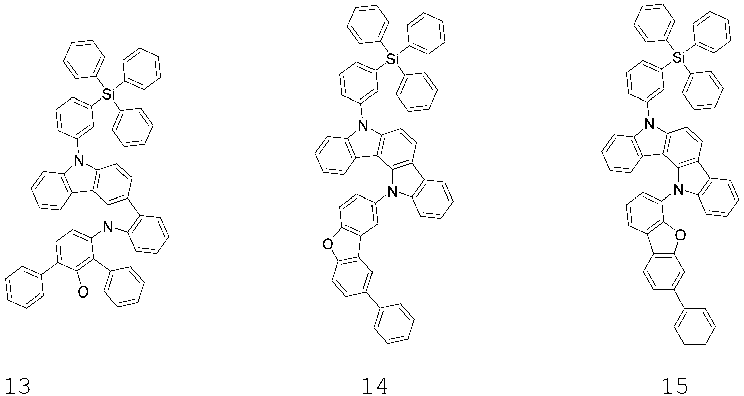

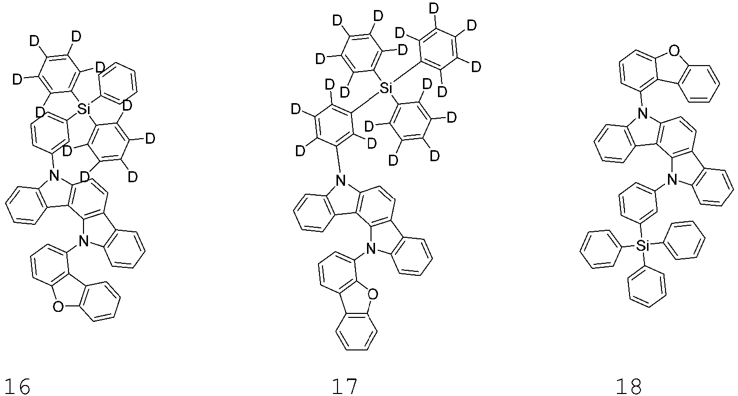

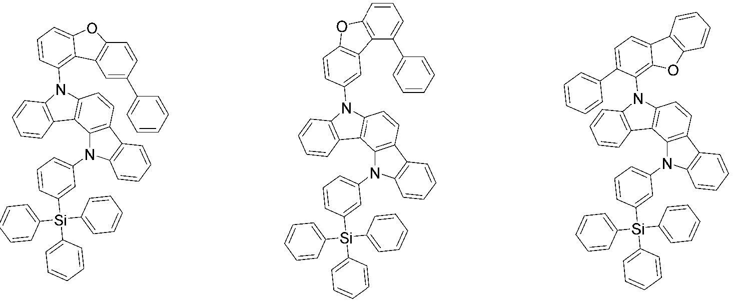

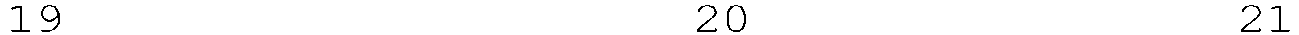

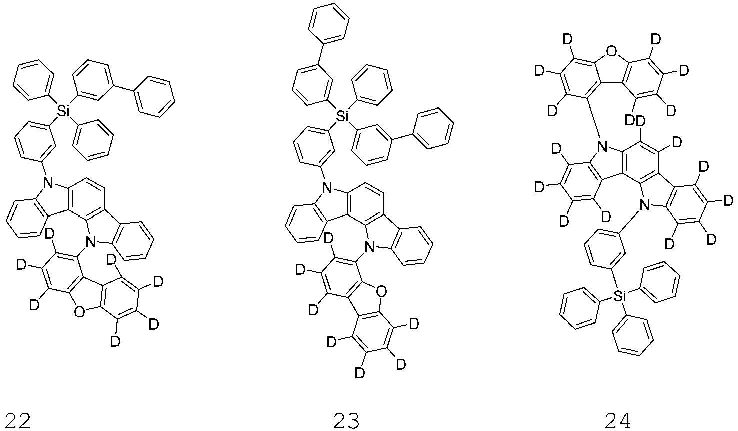

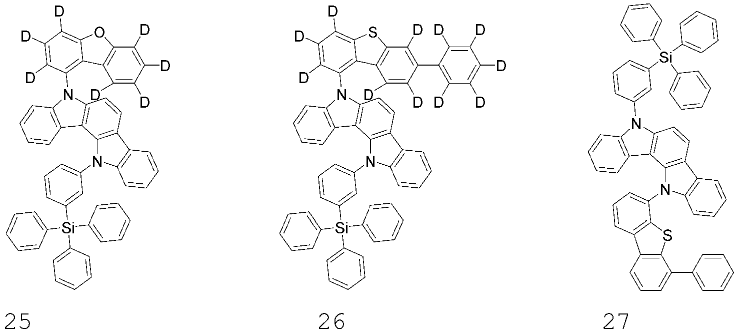

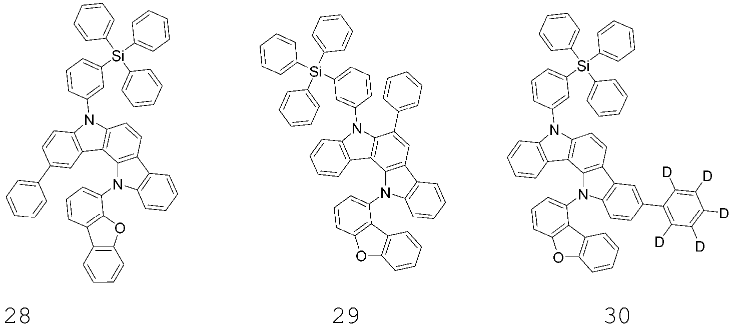

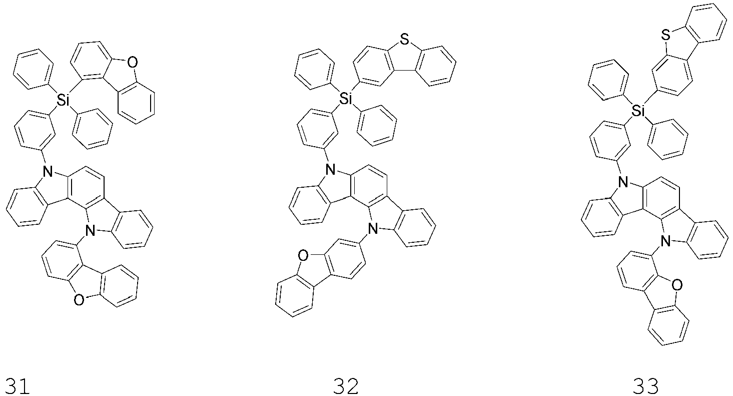

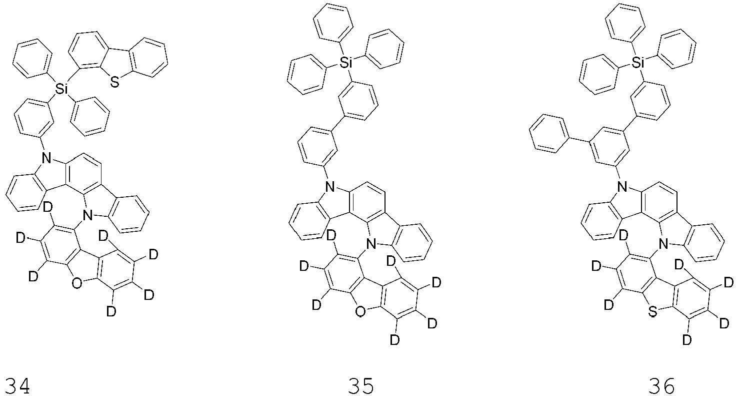

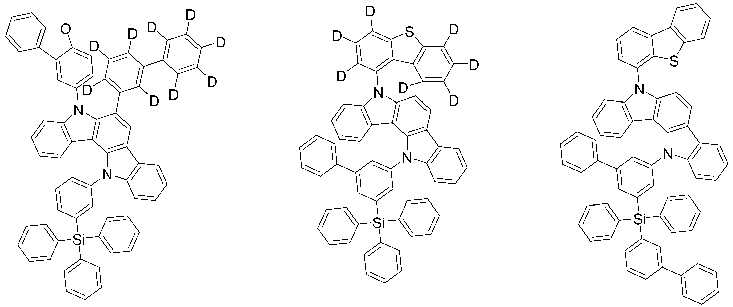

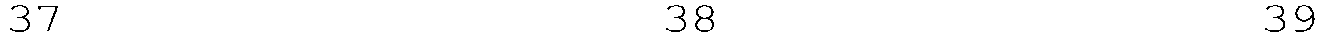

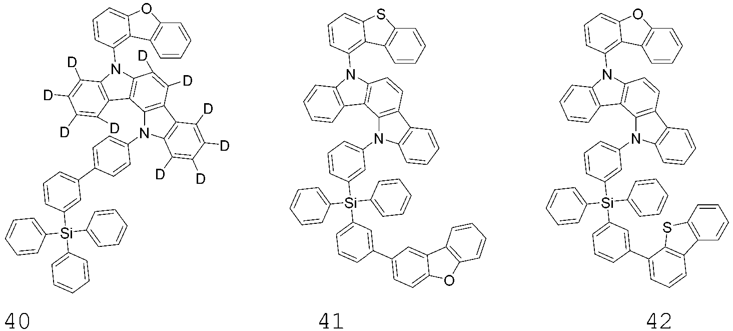

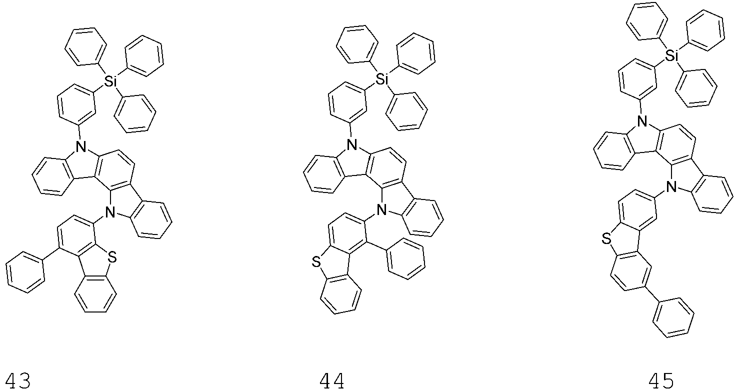

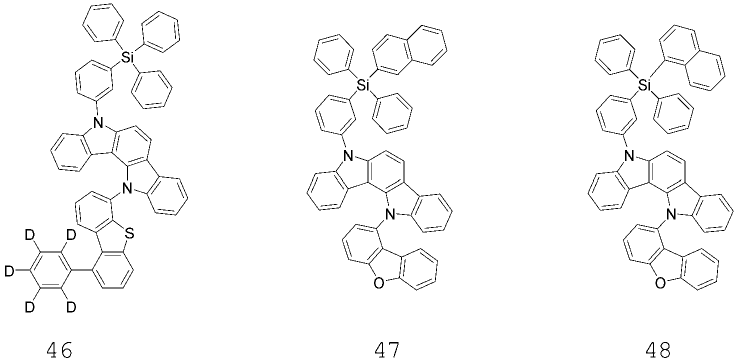

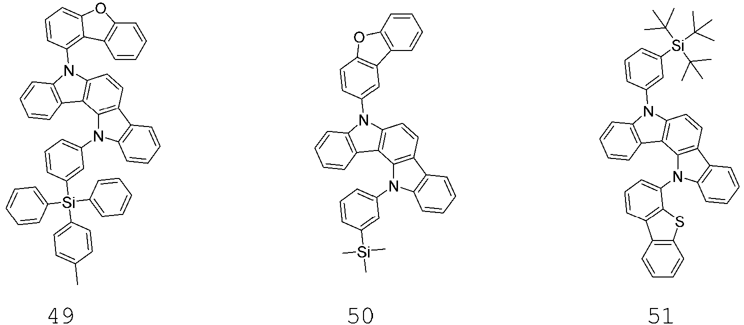

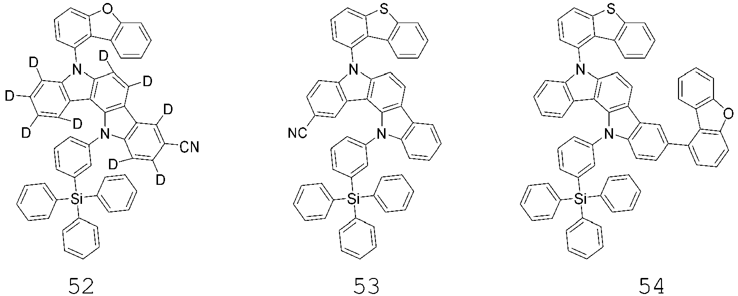

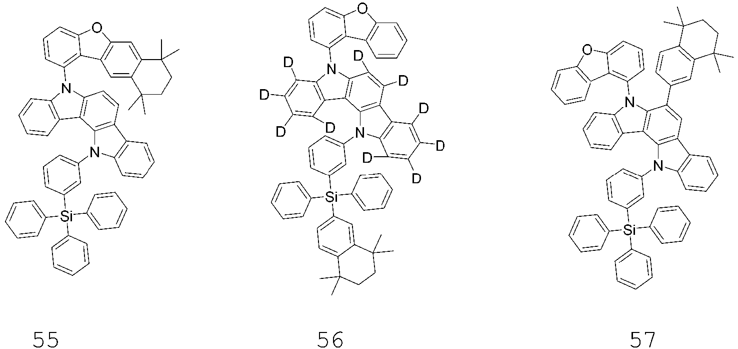

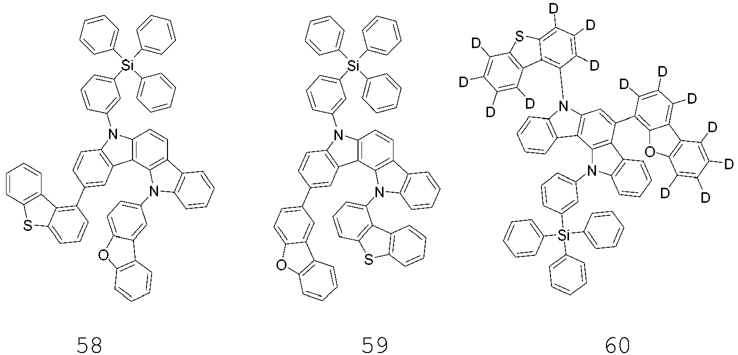

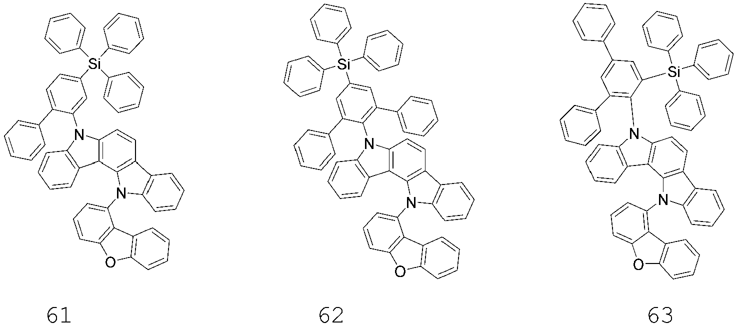

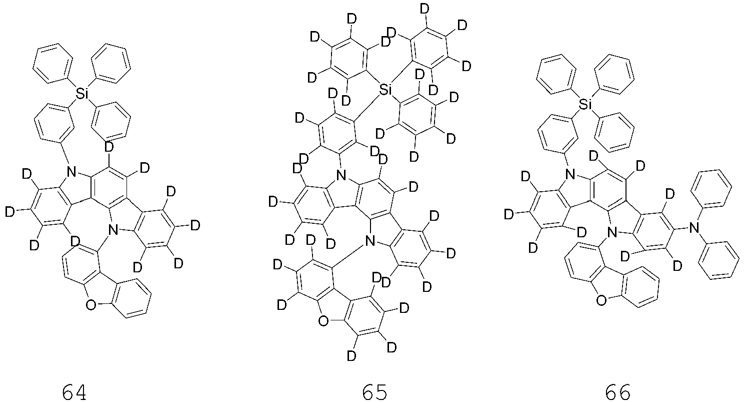

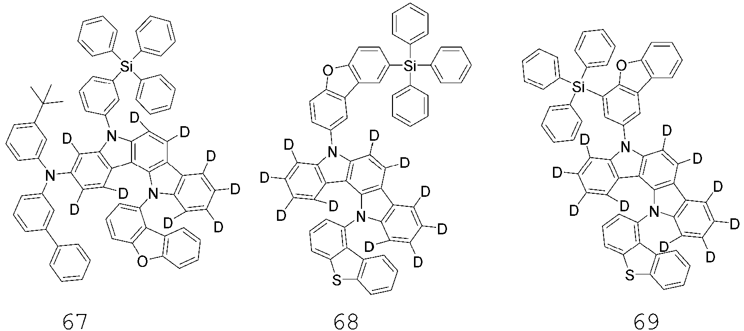

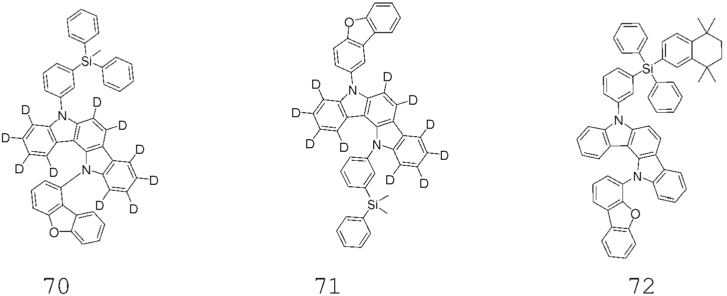

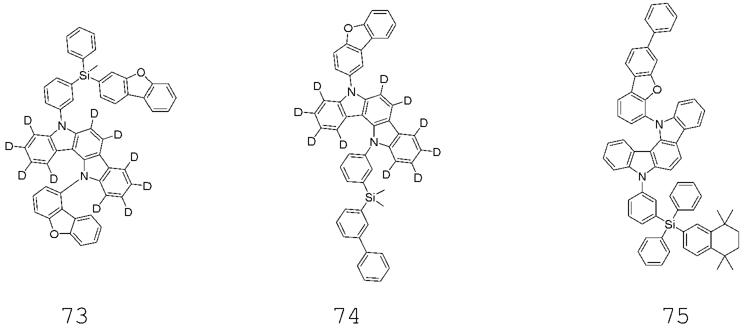

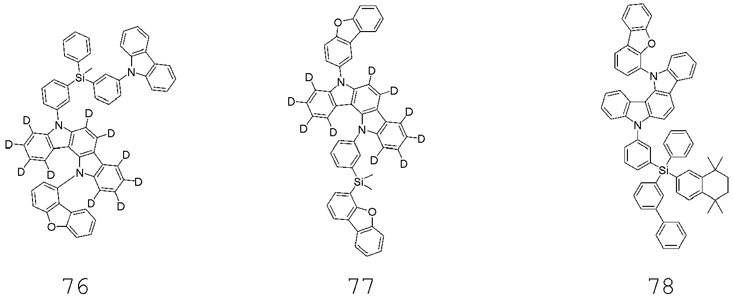

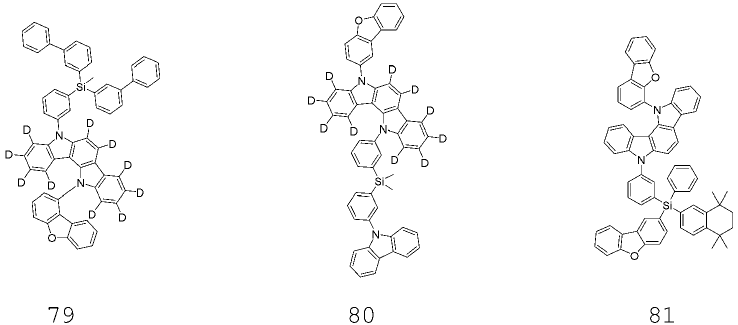

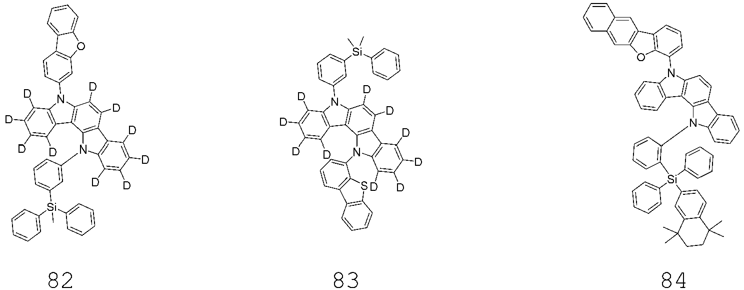

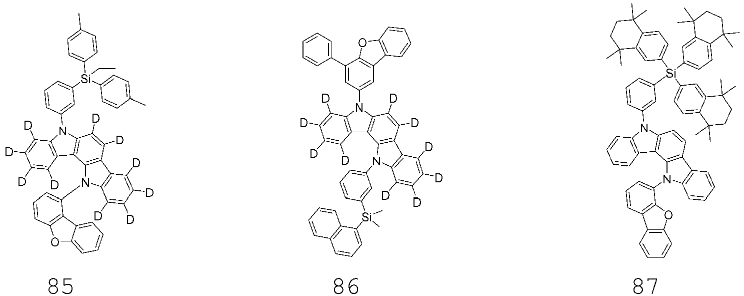

In addition, the present disclosure provides an organic light-emitting diode, including: a first electrode; a second electrode facing the first electrode; and an organic layer disposed between the first electrode and the second electrode, wherein the organic layer includes an emission layer containing a host and a dopant and the host in the emission layer includes at least one of the heterocyclic compounds described above according to the present disclosure. The organic light-emitting diode can exhibit low-voltage driving, high efficiency, and long lifespan characteristics.

Herein, the organic layer may further include at least one layer selected from a hole injection layer, a hole transport layer, a functional layer capable of both hole injection and hole transport, an electron blocking layer, an electron transport layer, an electron injection layer, a functional layer capable of both electron injection and electron transport, and a hole blocking layer.

Throughout the description of the present disclosure, the phrase "(organic layer) includes at least one organic compound" may be construed to mean that "(organic layer) may include a single organic compound species or two or more different species of organic compounds falling within the scope of the present disclosure".

According to a more preferred embodiment thereof, the present disclosure may provide an organic light-emitting diode including: a first electrode; a second electrode facing the first electrode; and an organic layer interposed between the first electrode and the second electrode, wherein the organic layer includes: an emission layer including a host and a dopant; and at least one layer selected from a hole injection layer, a hole transport layer, a functional layer capable of both hole injection and hole transport, an electron blocking layer, a hole blocking layer, an electron transport layer, and an electron injection layer, and the host includes one or more heterocyclic compounds according to the present disclosure. In this regard, the heterocyclic compound represented by Chemical Formula 1 according to the present disclosure may be used as a blue phosphorescent host.

In the present disclosure, a dopant material may be used, together with the host, in the emission layer. When the emission layer includes the host and the dopant, the content of the dopant may generally be selected within a range of about 0.01 to about 20 parts by weight based on 100 parts by weight of the host, without being limited thereto.

In an embodiment of the present disclosure, the emission layer of the organic light-emitting diode further comprises a host compound different from the heterocyclic compound, the host compound and the heterocyclic compound being used in mixture or stacked. That is, the host according to the present disclosure may include, in addition to one compound represented by Chemical Formula 1, one or more additional host compounds different therefrom, such that two or more host compounds are mixed or stacked. In the case of stacking, a layer including the heterocyclic compound according to the present disclosure may be stacked above or below a layer including a host compound different from the heterocyclic compound.

Here, when two or more host compounds including one or more additional host compounds in addition to the compound represented by Chemical Formula 1 are mixed or stacked, a compound having an electron-accepting moiety may be more preferably used as the additional host. Due to high hole injection and electron injection barriers resulting from HOMO/LUMO levels formed by mixing or stacking with Chemical Formula 1 having an amine group as an electron-donating moiety, a recombination zone may be confined to an interface between the two hosts, thereby minimizing current loss and enabling realization of an organic light-emitting diode with high efficiency and long lifetime.

At this time, the compound having an electron-accepting moiety refers to a compound having a moiety that provides an environment capable of easily accepting electrons from the outside, such as azine compounds that are nitrogen-containing aromatic heterocycles including pyridine, pyrimidine, triazine, and the like, or compounds substituted with a cyano group (-CN). Preferably, the compound may include a heteroaryl group containing 1 to 3 nitrogen (N) atoms in a molecule, or an aryl group including 1 to 3 cyano groups (-CN) in a molecule.

More specifically, in the emission layer of the organic light-emitting diode, at least one of the organic compounds represented by the following Chemical Formula B may be used as a host in mixture with the heterocyclic compound represented by Chemical Formula 1 or may be stacked above or below the layer containing the heterocyclic compound represented by Chemical Formula 1: 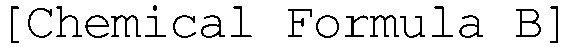 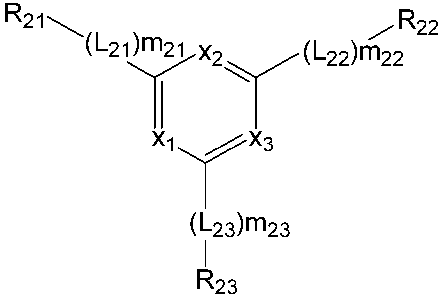 wherein,
X₁ to X₃, which are same or different, are each independently N or CR₂₄, with a proviso that at least one of X₁ to X₃ is N, wherein when two of X₁ to X₃ are CR₂₄, the corresponding CR₂₄ radicals are same or different,
L₂₁ to L₂₃, which are same or different, are each independently any one selected from a single bond, a substituted or unsubstituted arylene of 6 to 20 carbon atoms, a substituted or unsubstituted heteroarylene of 3 to 20 carbon atoms, and a substituted or unsubstituted, aliphatic hydrocarbon ring-fused arylene of 8 to 20 carbon atoms,
m₂₁ to m₂₃, which are same or different, are each independently an integer of 1 to 2, wherein when they are 2, the corresponding L₂₁ to L₂₃ radicals are individually same or different, and
R₂₁ to R₂₄, which are same or different, are each independently any one selected from a hydrogen atom, a deuterium atom, a tritium atom, a substituted or unsubstituted alkyl of 1 to 30 carbon atoms, a substituted or unsubstituted halogenated alkyl of 1 to 30 carbon atoms, a substituted or unsubstituted alkenyl of 2 to 30 carbon atoms, a substituted or unsubstituted alkynyl of 2 to 30 carbon atoms, a substituted or unsubstituted aryl of 6 to 50 carbon atoms, a substituted or unsubstituted cycloalkyl of 3 to 30 carbon atoms, a substituted or unsubstituted cycloalkenyl of 5 to 30 carbon atoms, a substituted or unsubstituted heterocycloalkyl of 2 to 30 carbon atoms, a substituted or unsubstituted heteroalkyl of 2 to 50 carbon atoms, a substituted or unsubstituted heteroaryl of 2 to 50 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted alkoxy of 1 to 30 carbon atoms, a substituted or unsubstituted aryloxy of 6 to 30 carbon atoms, a substituted or unsubstituted cycloalkyloxy of 3 to 30 carbon atoms, a substituted or unsubstituted heteroaryloxy of 2 to 30 carbon atoms, a substituted or unsubstituted alkylthio of 1 to 30 carbon atoms, a substituted or unsubstituted arylthio of 6 to 30 carbon atoms, a substituted or unsubstituted cycloalkylthio of 3 to 30 carbon atoms, a substituted or unsubstituted heteroarylthio of 2 to 30 carbon atoms, a substituted or unsubstituted amine of 0 to 40 carbon atoms, a substituted or unsubstituted silyl of 0 to 40 carbon atoms, a germanium of 0 to 40 carbon atoms, a nitro, a cyano, and a halogen atom,
wherein the term "substituted" in the expression "substituted or unsubstituted" used for the compound of Chemical Formula B means having at least one substituent selected from the group consisting of a deuterium atom, a tritium atom, a cyano, a halogen, a hydroxy, a nitro, an alkyl of 1 to 30 carbon atoms, a halogenated alkyl of 1 to 30 carbon atoms, an alkenyl of 2 to 30 carbon atoms, an alkynyl of 2 to 30 carbon atoms, a cycloalkyl of 3 to 30 carbon atoms, a heteroalkyl of 1 to 30 carbon atoms, an aryl of 6 to 30 carbon atoms, an arylalkyl of 7 to 30 carbon atoms, an alkylaryl of 7 to 30 carbon atoms, a heteroaryl of 2 to 30 carbon atoms, a heteroarylalkyl of 3 to 30 carbon atoms, an alkylheteroaryl of 3 to 30 carbon atoms, an alkoxy of 1 to 30 carbon atoms, an aromatic hydrocarbon ring-fused cycloalkyl of 7 to 30 carbon atoms, a heteroaromatic ring-fused cycloalkyl of 5 to 30 carbon atoms, an aromatic hydrocarbon ring-fused heterocycloalkyl of 6 to 30 carbon atoms, an aliphatic hydrocarbon ring-fused aryl of 7 to 30 carbon atoms, an aliphatic hydrocarbon ring-fused heteroaryl of 5 to 30 carbon atoms, a substituted or unsubstituted heteroaliphatic ring-fused aryl of 6 to 30 carbon atoms, a substituted or unsubstituted heteroaliphatic ring-fused heteroaryl of 5 to 30 carbon atoms, an amine of 1 to 30 carbon atoms, a silyl of 1 to 30 carbon atoms, a germanium of 1 to 30 carbon atoms, an aryloxy of 6 to 30 carbon atoms, and an arylthionyl of 6 to 30 carbon atoms, with at least one hydrogen atom on the substituent being substitutable with a deuterium or tritium atom.

In a more preferred embodiment of the present disclosure, X₁ to X₃ in Chemical Formula B may each be N, and at least one of R₂₁ to R₂₃ may be a substituted or unsubstituted carbazole.

In the present disclosure, a dopant material may be used, together with the host, in the emission layer. When the emission layer includes the host and the dopant, the content of the dopant may generally be selected within a range of about 0.01 to about 20 parts by weight based on 100 parts by weight of the host, without being limited thereto.

More specifically, the dopant in the emission layer of the organic light-emitting diode according to the present disclosure may be an organometallic compound containing a transition metal. In this regard, the dopant is not a fluorescent dopant material that undergoes transition only to a singlet state via Förster energy transfer in a conventional host-dopant system, but rather a phosphorescent dopant material that undergoes transition without distinguishing between singlet and triplet states via Dexter energy transfer, and includes a metal complex containing one or more metals selected from Ir, Pt, Os, Ti, Zr, Hf, Eu, Tb, Tm, Fe, Co, Ni, Ru, Rh, Re, and Pd. Any known dopant material that emits light from a triplet excited state may be used without particular limitation.

The dopant material is preferably a transition metal complex, and Ir, Pt, and Pd may be selected. Specific examples include, but are not limited thereto, Ir(ppy)₃, Ir(ppy)₂acac, Ir(Bt)₂acac, Ir(MDQ)₂acac, Ir(mppy)₃, Ir(piq)₃, Ir(piq)₂acac, Ir(pq)₂acac, Ir(mpp)₂acac, F₂Irpic, (F₂ppy)₂Ir(tmd) , Ir(ppy)₂tmd, Ir(pmi)₃, Ir(pmb)₃, FCNIr, FCNIrpic, FIr6, FIrN4, FIrpic, PtOEP, Ir(chpy)₃, P0-01(C₃₁H₂₃IrN₂O₂S₂), Ir(ppz)₃, Ir(dfppz)_{3,}PtNON, Pt-10, and Pt-11, with more preference for PtOEP, Ir(Bt)₂acac, Ir(MDQ)₂acac, Ir(piq)₃, Ir(piq)₂acac, Ir(pq)₂acac as red phosphorescent dopants.

In addition to the dopant and the host, the emission layer may further include various hosts and various dopant materials. Preferably, in the emission layer of the organic light-emitting diode, one or more dopant compounds containing boron, which are different from the organometallic compound containing the transition metal, may be mixed or stacked together with the dopant.

More specifically, in the emission layer of the organic light-emitting diode, one or more polycyclic compounds represented by the following Chemical Formula 2 may be used in mixture with the organometallic compound containing the transition metal or may be used by stacking the polycyclic compound represented by [Chemical Formula 2] on an upper or lower surface of a layer including the organometallic compound:

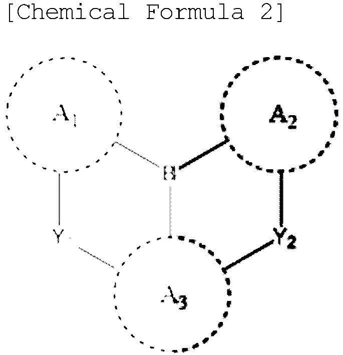

wherein,
Y₁ and Y₂, which are same or different, are each independently any one selected from O, S, NR₁₁, CR₁₂R₁₃, SiR₁₄R₁₅, and GeR₁₆R₁₇,
A₁ to A₃, which are same or different, are each independently any one selected from a substituted or unsubstituted aromatic hydrocarbon ring of 6 to 50 carbon atoms, a substituted or unsubstituted aliphatic hydrocarbon ring of 5 to 50 carbon atoms, a substituted or unsubstituted, aliphatic hydrocarbon ring-fused aromatic hydrocarbon ring of 8 to 50 carbon atoms, a substituted or unsubstituted heteroaromatic ring of 2 to 50 carbon atoms, and a substituted or unsubstituted, aliphatic hydrocarbon ring-fused heteroaromatic ring of 5 to 50 carbon atoms,
R₁₁ to R₁₇, which are same or different, are each independently any one selected from a hydrogen atom, a deuterium atom, a tritium atom, a substituted or unsubstituted alkyl of 1 to 30 carbon atoms, a substituted or unsubstituted halogenated alkyl of 1 to 30 carbon atoms, a substituted or unsubstituted alkenyl of 2 to 30 carbon atoms, a substituted or unsubstituted alkynyl of 2 to 30 carbon atoms, a substituted or unsubstituted aryl of 6 to 50 carbon atoms, a substituted or unsubstituted cycloalkyl of 3 to 30 carbon atoms, a substituted or unsubstituted cycloalkenyl of 5 to 30 carbon atoms, a substituted or unsubstituted heterocycloalkyl of 2 to 30 carbon atoms, a substituted or unsubstituted heteroalkyl of 2 to 50 carbon atoms, a substituted or unsubstituted heteroaryl of 2 to 50 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted alkoxy of 1 to 30 carbon atoms, a substituted or unsubstituted aryloxy of 6 to 30 carbon atoms, a substituted or unsubstituted cycloalkyloxy of 3 to 30 carbon atoms, a substituted or unsubstituted heteroaryloxy of 2 to 30 carbon atoms, a substituted or unsubstituted alkylthio of 1 to 30 carbon atoms, a substituted or unsubstituted arylthio of 6 to 30 carbon atoms, a substituted or unsubstituted cycloalkylthio of 3 to 30 carbon atoms, a substituted or unsubstituted heteroarylthio of 2 to 30 carbon atoms, a substituted or unsubstituted amine of 0 to 40 carbon atoms, a substituted or unsubstituted silyl of 0 to 40 carbon atoms, a germanium of 0 to 40 carbon atoms, a nitro, a cyano, and a halogen,
R₁₁ to R₁₇ may be connected to the A₁ to A₃ ring moieties to additionally form an aliphatic or aromatic mono-or polycyclic ring, and
a linkage may be made between R₁₂ and R₁₃, between R₁₄ and R₁₅, and between R₁₆ and R₁₇ to additionally form respective mono- or polycyclic aliphatic or aromatic rings,
wherein the term "substituted" in the expression "substituted or unsubstituted" used for the compound of Chemical Formula 2 means having at least one substituent selected from the group consisting of a deuterium atom, a tritium atom, a cyano, a halogen, a hydroxy, a nitro, alkyl of 1 to 30 carbon atoms, a halogenated alkyl of 1 to 30 carbon atoms, an alkenyl of 2 to 24 carbon atoms, an alkynyl of 2 to 24 carbon atoms, a cycloalkyl of 3 to 24 carbon atoms, a heteroalkyl of 1 to 24 carbon atoms, an aryl of 6 to 24 carbon atoms, an arylalkyl of 7 to 24 carbon atoms, an alkylaryl of 7 to 24 carbon atoms, a heteroaryl of 2 to 24 carbon atoms, a heteroarylalkyl of 3 to 24 carbon atoms, an alkylheteroaryl of 3 to 24 carbon atoms, an alkoxy of 1 to 24 carbon atoms, an aromatic hydrocarbon ring-fused cycloalkyl of 7 to 30 carbon atoms, a heteroaromatic ring-fused cycloalkyl of 5 to 30 carbon atoms, an aromatic hydrocarbon ring-fused heterocycloalkyl of 6 to 30 carbon atoms, an aliphatic hydrocarbon ring-fused aryl of 7 to 30 carbon atoms, an aliphatic hydrocarbon ring-fused heteroaryl of 5 to 30 carbon atoms, a substituted or unsubstituted heteroaliphatic ring-fused aryl of 6 to 30 carbon atoms, a substituted or unsubstituted heteroaliphatic ring-fused heteroaryl of 5 to 30 carbon atoms, an amine of 1 to 30 carbon atoms, a silyl of 1 to 30 carbon atoms, a germanium of 1 to 30 carbon atoms, an aryloxy of 6 to 24 carbon atoms, and an arylthionyl of 6 to 24 carbon atoms, with at least one hydrogen atom on the substituents being substitutable with a deuterium or tritium atom.

Herein, the polycyclic compound represented by Chemical Formula 2 is a boron-based thermally activated delayed fluorescence emitter, which enables Förster energy transfer from the triplet state of a phosphorescent sensitizer to the singlet state of the boron-based thermally activated delayed fluorescence emitter. Accordingly, the number of long-lived triplet excitons involved in device degradation can be reduced, thereby improving device lifetime. In addition, since the compound has a high molar extinction coefficient, the rate of fluorescence resonance energy transfer from the phosphorescent sensitizer to the emitter is increased, and the emission spectrum is narrowed due to a multiple-resonance effect, resulting in improved color purity. Owing to these effects, the compound has advantages in improving efficiency and lifetime.

In a more preferred embodiment of the present disclosure, A₁ to A₃ may be same as or different from each other, and each independently may be any one selected from a substituted or unsubstituted aromatic hydrocarbon ring of 6 to 30 carbon atoms, and a substituted or unsubstituted aliphatic hydrocarbon ring-fused aromatic hydrocarbon ring of 8 to 30 carbon atoms.

Below, with reference to the drawing, a description will be given of the organic light-emitting diode of the present disclosure.

FIGURE is a schematic view illustrating the structure of an organic light-emitting diode according to an embodiment of the present disclosure.

As shown in FIGURE, the organic light-emitting diode according to an embodiment of the present disclosure sequentially comprises an anode (20), a hole transport layer (40), an emission layer (50) containing a host and a dopant, an electron transport layer (60), and a cathode (80), wherein the anode and the cathode serve as a first electrode and a second electrode, respectively, with the interposition of the hole transport layer between the anode and the light emission layer, and the electron transport layer between the emission layer and the cathode.

Furthermore, the organic light-emitting diode according to an embodiment of the present disclosure may include a hole injection layer (30) between the anode (20) and the hole transport layer (40), and an electron injection layer (70) between the electron transport layer (60) and the cathode (80).

Reference is made to FIGURE with regard to the organic light-emitting diode of the present disclosure and the fabrication thereof.

First, a substrate (10) is coated with an anode material to form an anode (20). So long as it is used in a typical organic electroluminescence (EL) device, any substrate may be used as the substrate (10). Preferable is an organic substrate or transparent plastic substrate that exhibits excellent transparency, surface smoothness, ease of handling, and waterproofness. As the anode material, indium tin oxide (ITO), indium zinc oxide (IZO), tin oxide (SnO₂), or zinc oxide (ZnO), which are transparent and superior in terms of conductivity, may be used.

A hole injection layer material is applied on the anode (20) by thermal deposition in a vacuum or by spin coating to form a hole injection layer (30). Subsequently, thermal deposition in a vacuum or by spin coating may also be conducted to form a hole transport layer (40) with a hole transport layer material on the hole injection layer (30).

So long as it is typically used in the art, any material may be selected for the hole injection layer (30) without particular limitations thereto. Examples include, but are not limited to, 2-TNATA [4,4',4"-tris(2-naphthylphenyl-phenylamino)-triphenylamine], NPD[N,N'-di(1-naphthyl)-N,N'-diphenylbenzidine)], TPD[N,N'-diphenyl-N,N'-bis(3-methylphenyl)-1,1'-biphenyl-4,4'-diamine], DNTPD[N,N'-diphenyl-N,N'-bis-[4-(phenyl-m-tolyl-amino)-phenyl]-biphenyl-4,4'-diamine], and HAT-CN[1,4,5,8,9,11-Hexaazatriphenylenehexacarbonitrile].

Any material that is typically used in the art may be selected for the hole transport layer (40) without particular limitations thereto. Examples include, but are not limited to, N,N'-bis(3-methylphenyl)-N,N'-diphenyl-[1,1-biphenyl]-4,4'-diamine(TPD) or N,N'-di(naphthalen-1-yl)-N,N'-diphenylbenzidine (a-NPD), N-[[1,1'-biphenyl]-4-yl]-9,9-dimethyl-N-[4-(9-phenyl-9H-carbazol-3-yl)phenyl]-9H-fluorene-2-amine(BCFN), and the like.

In an embodiment of the present disclosure, an electron blocking layer may be additionally disposed on the hole transport layer. Functioning to prevent the electrons injected from the electron injection layer from entering the hole transport layer through the emission layer, the electron blocking layer is adapted to increase the life span and luminous efficiency of the diode. The electron blocking layer may be formed at a suitable position between the emission layer and the hole injection layer and particularly between the emission layer and the hole transport layer.

Subsequently, the emission layer (50) may be deposited on an upper side of the hole transport layer (40) or the electron blocking layer by deposition in a vacuum or by spin coating.

Here, the emission layer may be composed of a host and a dopant, and the materials constituting the layer are as previously described.

According to a specific embodiment of the present disclosure, the thickness of the emission layer may preferably range from 50 to 2,000 Å.

In the present disclosure, a hole blocking layer (not shown) may be formed on the organic emission layer (50) by vacuum deposition or spin coating.

The hole blocking layer serves to prevent a reduction in device lifetime and efficiency that may occur when holes pass through the light-emitting layer and flow into the cathode, by employing a material having a very low HOMO (Highest Occupied Molecular Orbital) level. At this time, the hole blocking material to be used is not particularly limited, as long as it has electron-transporting ability and a higher ionization potential than that of the light-emitting compound. Examples of materials that may be used in the hole blocking layer include BAlq, BCP, Bphen, TPBI, NTAZ, BeBq₂, OXD-7, Liq, and any one selected from Chemical Formula 1001 to Chemical Formula 1007, but are not limited thereto.

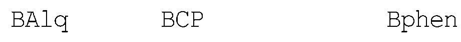

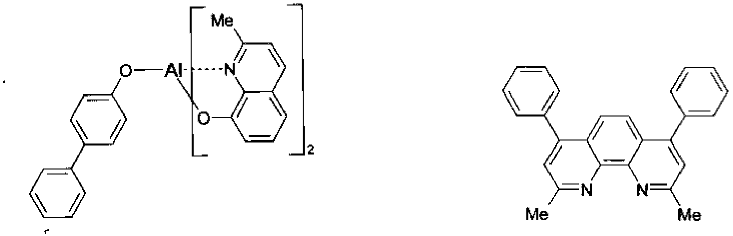

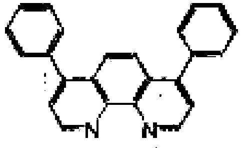

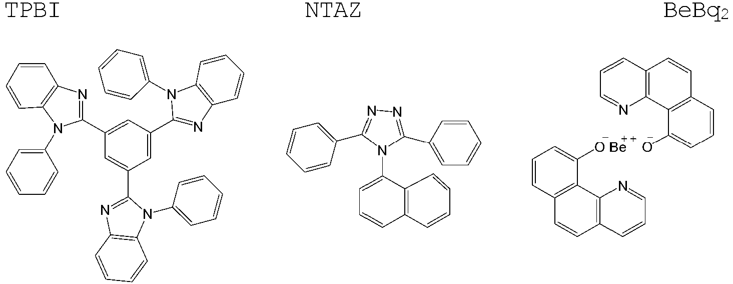

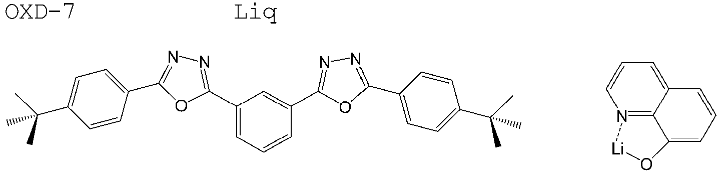

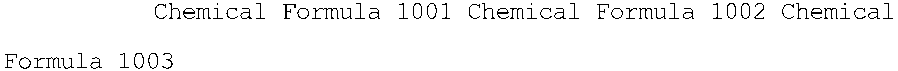

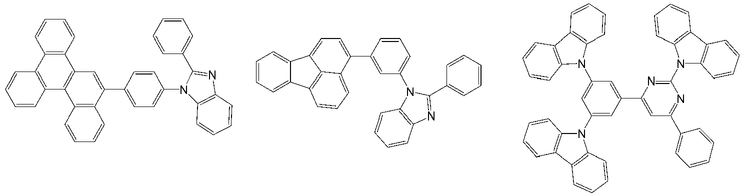

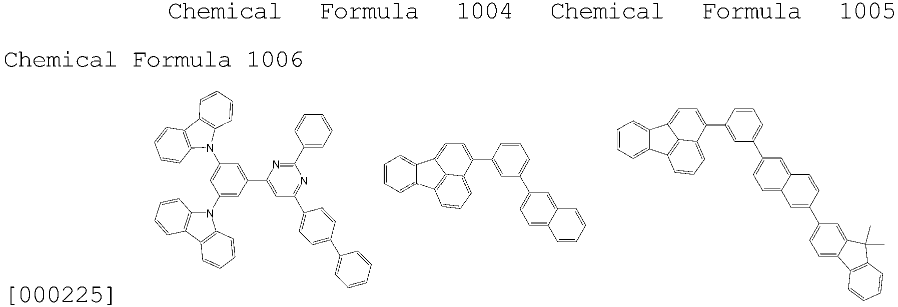

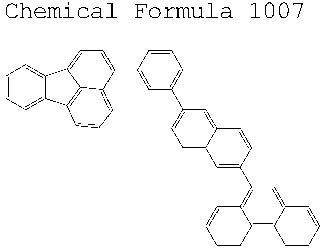

The electron transport layer (60) may be deposited on the emission layer by vacuum deposition or spin coating.

In the present disclosure, the electron transport layer (60) functions to stably transport electrons injected from the electron-injecting electrode (cathode), and known electron transport materials may be used. Examples of such known materials include quinoline derivatives, particularly tris (8-quinolinolato) aluminum (Alq₃), Liq, TAZ, BAlq, beryllium bis (benzoquinolin-10-olate) (Bebq2), Compound 201, Compound 202, BCP, and oxadiazole derivatives such as PBD, BMD, and BND, but are not limited thereto:

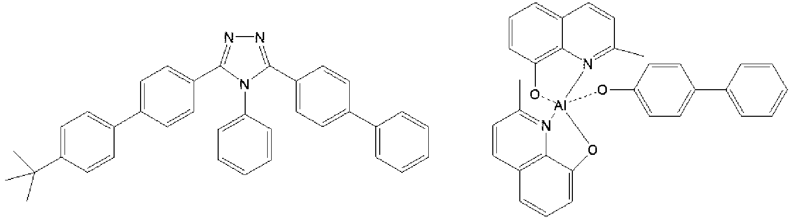

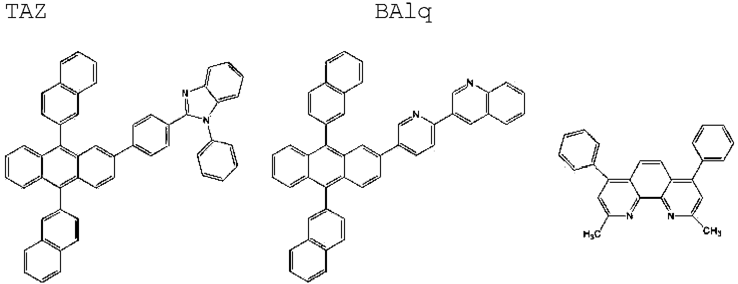

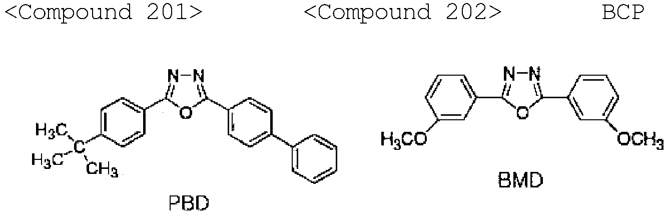

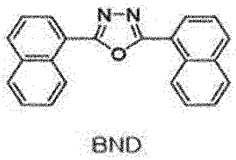

In the organic light-emitting diode of the present disclosure, an electron injection layer (EIL) that functions to facilitate electron injection from the cathode may be formed on the electron transport layer. The material for the EIL is not particularly limited.

Any material that is conventionally used in the art can be available for the electron injection layer. Examples include CsF, NaF, LiF, Li₂O, and BaO. Deposition conditions for the electron injection layer may vary, depending on compounds used, but may be generally selected from condition scopes that are almost the same as for the formation of hole injection layers.

The electron injection layer may range in thickness from about 1 Å to about 100 Å, and particularly from about 3 Å to about 90 Å. Given the thickness range for the electron injection layer, the diode can exhibit satisfactory electron injection properties without actually elevating a driving voltage.

In order to facilitate electron injection, the cathode may be made of a material having a small work function, such as metal or metal alloy such as lithium (Li), magnesium (Mg), calcium (Ca), an alloy aluminum (Al) thereof, aluminum-lithium (Al-Li), magnesium-indium (Mg-In), and magnesium-silver (Mg-Ag). Alternatively, ITO or IZO may be employed to form a transparent cathode for an organic light-emitting diode.

Furthermore, at least one selected from among the layers may be deposited using a single-molecule deposition process or a solution process.

Here, the deposition process is a process by which a material is vaporized in a vacuum or at a low pressure and deposited to form a layer, and the solution process is a method in which a material is dissolved in a solvent and applied for the formation of a thin film by means of inkjet printing, roll-to-roll coating, screen printing, spray coating, dip coating, spin coating, etc.

Also, the organic light-emitting diode of the present disclosure may be applied to a device selected from among flat display devices; flexible display devices; monochrome or grayscale flat illumination devices; monochrome or grayscale flexible illumination devices; vehicle or aircraft display devices, and display devices for virtual or augmented reality.

A better understanding of the present disclosure may be obtained through the following examples which are set forth to illustrate, but are not to be construed as limiting the present disclosure.

### (EXAMPLES)

### SYNTHESIS EXAMPLE 1. Synthesis of [Compound 2]

### Synthesis Example 1-1. Synthesis of A-1

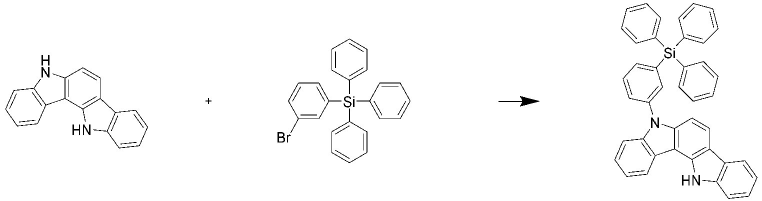

### <A-1a> <A-1b> <A-1>

In a round-bottom flask, <A-1a> (30 g), <A-1b> (76.4 g), copper iodide (1.7 g), potassium phosphate (76.2 g), 1,2-cyclohexane diamine (cis : trans = 50:50) (41.1 g), and 1,4-dioxane (750 mL) were refluxed together for 12 hours. After completion of the reaction, the reaction mixture was cooled to room temperature and filtered through celite, followed by concentration of the filtrate in a vacuum. The resulting concentrate was recrystallized in tetrahydrofuran and heptane to afford <A-1>. (67.5 g, 62%)

### Synthesis Example 1-2. Synthesis of [Compound 2]

### <A-1> <A-2a> [Compound 2]

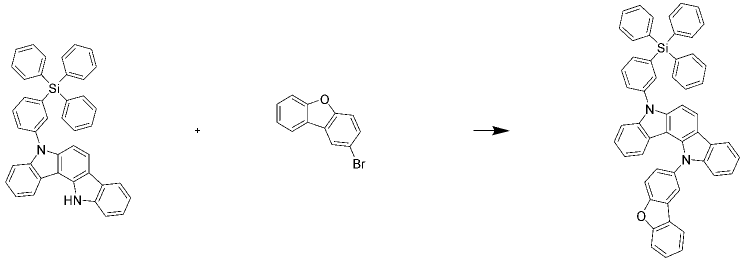

In a round-bottom flask, <A-1> (10 g), <A-2a> (5.4 g), tris(dibenzylideneacetone)dipalladium (0.5 g), sodium tert-butoxide (4.9 g), tris-tert-butyl phosphine (0.3 g), and toluene (100 mL) were refluxed together for 3 hours. After completion of the reaction, the reaction mixture was cooled to room temperature, added with drops of methanol, and stirred. The solid thus obtained was recrystallized in tetrahydrofuran and acetone to afford [Compound 2]. (5.6 g, 41.4%)
MS (MALDI-TOF) : m/z 756.26 [M ⁺]

### SYNTHESIS EXAMPLE 2. Synthesis of [Compound 11]

### Synthesis Example 2-1. Synthesis of B-1

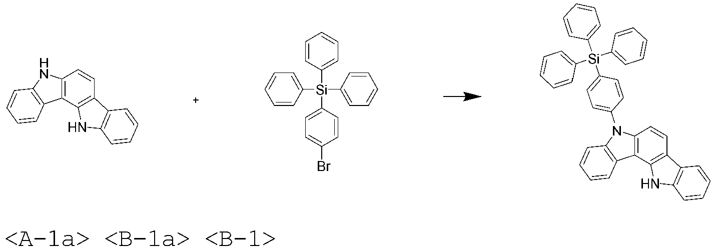

The same procedure as in Synthesis Example 1-2, with the exception of using <B-1a> instead of <A-1b>, was carried out to afford <B-1>. (yield 63.7%)

### Synthesis Example 2-2. Synthesis of [Compound 11]

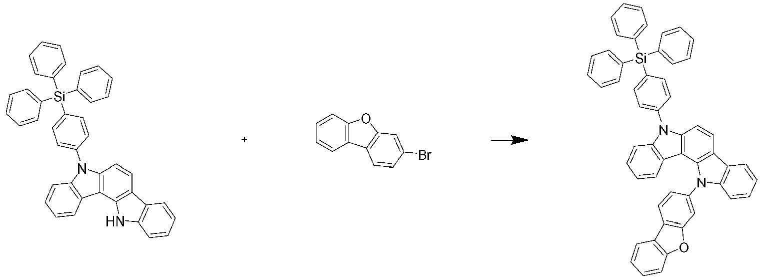

### <B-1> <B-2a> [Compound 11]

The same procedure as in Synthesis Example 1-2, with the exception of using <B-1> and <B-2a> instead of <A-1> and <A-2a>, respectively, was carried out to afford [Compound 11]. (yield 32.7%)
MS (MALDI-TOF) : m/z 756.26 [M ⁺]

### SYNTHESIS EXAMPLE 3. Synthesis of [Compound 15]

### Synthesis Example 3-1. Synthesis of C-1

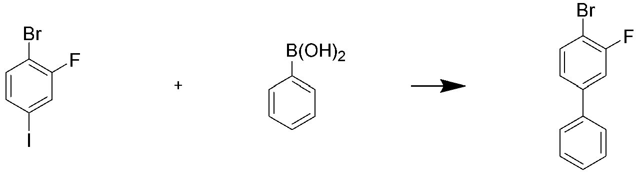

### <C-1a> <C-1b> <C-1>

In a round-bottom flask, <C-1a> (150 g), <C-1b> (60.8 g), tetrakis(triphenylphosphine)palladium (17.3 g), potassium carbonate (137.9 g), toluene (1050 mL), ethanol (260 mL), and water (500 mL) were refluxed for 8 hours. After completion of the reaction, the reaction mixture was cooled to room temperature and subjected to layer separation with ethyl acetate and water. The organic layer thus obtained was concentrated in a vacuum, followed by purification through column chromatography to afford <C-1>. (79.8 g, 63.7%)

### Synthesis Example 3-2. Synthesis of C-2

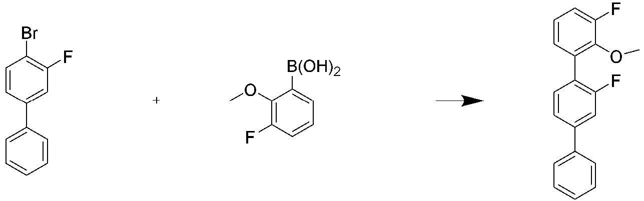

### <C-1> <C-2a> <C-2>

In a round-bottom flask, <C-1> 79.8 g, <C-2a> 64.5 g, tetrakis(triphenylphosphine)palladium (11 g), potassium carbonate (87.5 g), toluene (560 mL), dioxane (450 mL), and water (315 mL) were refluxed for 12 hours. After completion of the reaction, the reaction mixture was cooled to room temperature and subjected to layer separation with ethyl acetate and water. The organic layer thus obtained was dehydrated and concentrated in a vacuum. Thereafter, purification by column chromatography afforded <C-2>. (64 g, 68.4%)

### Synthesis Example 3-3. Synthesis of C-3

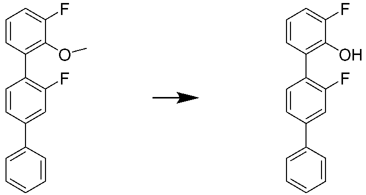

### <C-2> <C-3>

In a round-bottom flask, a mixture of <C-2> (64 g) and dichloromethane (640 mL) was cooled to 0°C under a nitrogen atmosphere. Then, drops of boron tribromide (162.4 g) were slowly added, after which the mixture was warmed to room temperature and stirred for 8 hours. After completion of the reaction, the reaction mixture was poured into water, stirred for 30 minutes, and subjected to layer separation with dichloromethane and water. The organic layer thus obtained was dehydrated, concentrated at a reduced pressure, and dried in a vacuum to afford <C-3>. (56.5 g, 92.5%)

### Synthesis Example 3-4. Synthesis of C-4

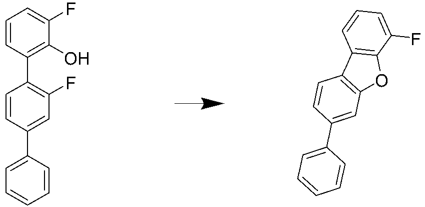

### <C-3> <C-4>

In a round-bottom flask, <C-3> (56.5 g), potassium carbonate (82.9 g), and N,N-dimethylacetamide (570 mL) were refluxed for 24 hours. After completion of the reaction, the reaction mixture was cooled to room temperature and poured into water to precipitate crystals which were then stirred for 1 hour and filtered. The solid filtrate was washed with methanol and recrystallized in dichloromethane and methanol to afford <C-4>. (40 g, 76.3%)

### Synthesis Example 3-5. Synthesis of [Compound 15]

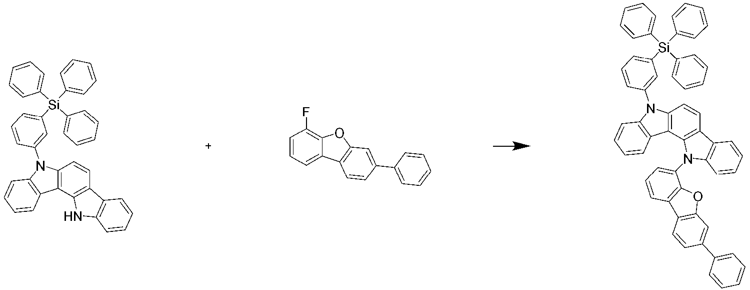

### <A-1> <C-4> [Compound 15]

In a round-bottom flask, <A-1> (12 g), <C-4> (6.4 g), cesium carbonate (19.9 g), and N,N-dimethylacetamide (100 mL) were refluxed together for 24 hours. After completion of the reaction, the reaction mixture was cooled to room temperature, poured to water, stirred for 1 hour, and filtered. The filtrate was washed with methanol and purified by column chromatography to afford [Compound 15]. (7.5 g, 44.3%)
MS (MALDI-TOF) : m/z 832.29 [M ⁺]

### SYNTHESIS EXAMPLE 4. Synthesis of [Compound 20]

### Synthesis Example 4-1. Synthesis of D-1

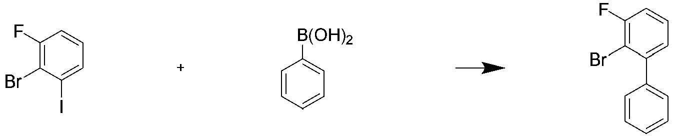

### <D-1a> <C-1b> <D-1>

The same procedure as in Synthesis Example 3-1, with the exception of using <D-1a> instead of <C-1a>, was carried out to afford <D-1>. (yield 62.5%)

### Synthesis Example 4-2. Synthesis of D-2

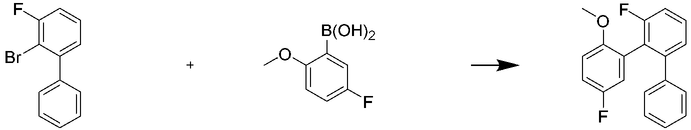

### <D-1> <D-2a> <D-2>

The same procedure as in Synthesis Example 3-2, with the exception of using <D-1> and <D-2a> instead of <C-1> and <C-2a>, respectively, was carried out to afford <D-2>. (yield 68.1%)

### Synthesis Example 4-3. Synthesis of D-3

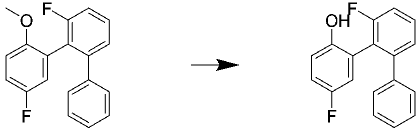

### <D-2> <D-3>

The same procedure as in Synthesis Example 3-3, with the exception of using <D-2> instead of <C-2>, was carried out to afford <D-3>. (yield 90.2%)

### Synthesis Example 4-4. Synthesis of D-4

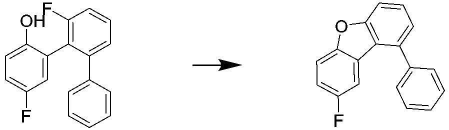

### <D-3> <D-4>

The same procedure as in Synthesis Example 3-4, with the exception of using <D-3> instead of <C-3>, was carried out to afford <D-4>. (yield 75.7%)

### Synthesis Example 4-5. Synthesis of D-5

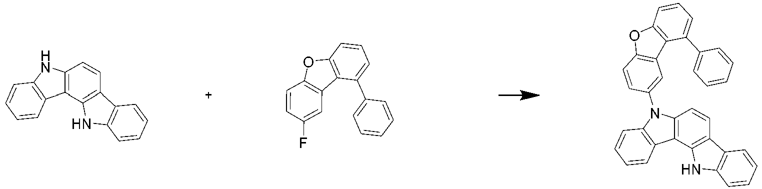

### <A-1a> <D-4> <D-5>

The same procedure as in Synthesis Example 3-5, with the exception of using <A-1a> and <D-4> instead of <A-1> and <C-4>, respectively, was carried out to afford <D-5>. (yield 72.3%)

### Synthesis Example 4-6. Synthesis of [Compound 20]

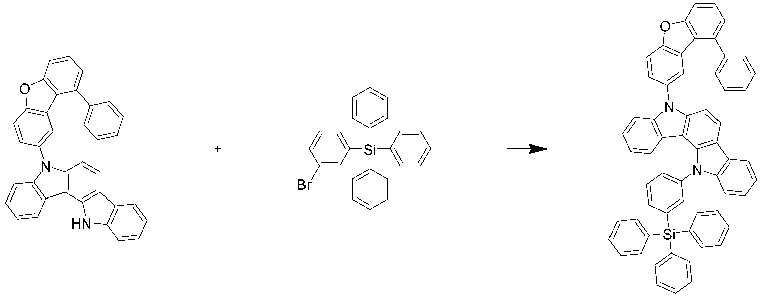

### <D-5> <A-1b> [Compound 20]

The same procedure as in Synthesis Example 1-2, with the exception of using <D-5> and <A-1b> instead of <A-1> and <A-2a>, respectively, was carried out to afford [Compound 20]. (yield 43.3%)
MS (MALDI-TOF) : m/z 832.29 [M ⁺]

### SYNTHESIS EXAMPLE 5. Synthesis of [Compound 28]

### Synthesis Example 5-1. Synthesis of E-1

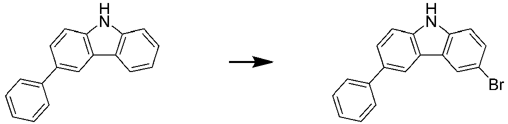

### <E-1a> <E-1>

In a round-bottom flask, <E-1a> (40 g) and N,N-dimethylformamide (600 mL) were cooled together to 0°C. A solution of N-bromosuccinimide (35.1 g) in N,N-dimethylformamide (175 mL) was dropwise added and stirred for 6 hours at room temperature. After completion of the reaction, the reaction mixture was poured to heptane, stirred for 1 hour, and filtered to afford <E-1>. (47.8 g, 90.2%)

### Synthesis Example 5-2. Synthesis of <E-2>

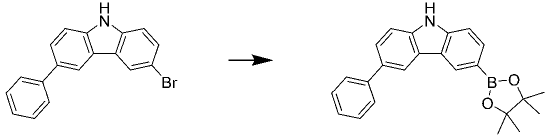

### <E-1> <E-2>

In a round-bottom flask, <E-1> 47.8 g, bis(pinacolato)diboron (49 g), diphenylphosphine palladium dichloride (14.1 g), potassium acetate (43.7 g), and 1,4-dioxane (480 mL) were refluxed for 7 hours. After completion of the reaction, the reaction mixture was cooled to room temperature and filtered through celite. The filtrate was concentrated, followed by precipitation of crystals in heptane. The solid obtained by filtration was dissolved in toluene and filtered through silica gel. The filtrate was concentrated and recrystallized in heptane. The crystals thus obtained were filtered to afford <E-2>. (47.7 g, 87.2%)

### Synthesis Example 5-3. Synthesis of <E-3>

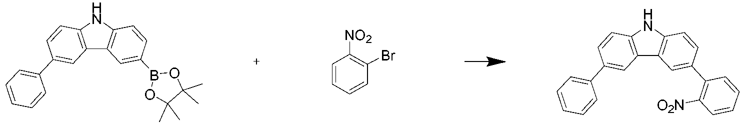

### <E-2> <E-3a> <E-3>

The same procedure as in Synthesis Example 3-2, with the exception of using <E-3a> and <E-2> instead of <C-1> and <C-2a>, respectively, was carried out to afford <E-3>. (yield 58.8%)

### Synthesis Example 5-4. Synthesis of <E-4>

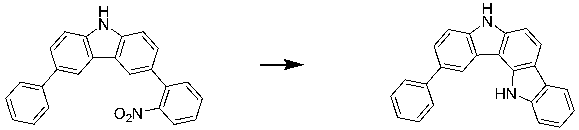

### <E-3> <E-4>

In a round-bottom flask, <E-3> (27.6 g), triphenylphosphine (59.6 g), and 1,2-dichlorobenzene (280 mL) were stirred together for 15 hours. After completion of the reaction, the reaction mixture was cooled to room temperature, concentrated at a reduced pressure, and purified through column chromatography to afford <E-4>. (16.2 g, yield 64.5%)

### Synthesis Example 5-5. Synthesis of <E-5>

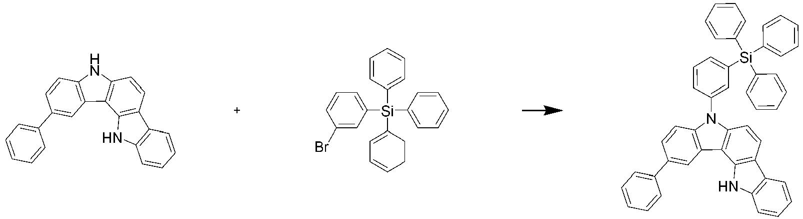

### <E-4> <A-1b> <E-5>

The same procedure as in Synthesis Example 1-1, with the exception of using <E-4> instead of <A-1a>, was carried out to afford <E-5>. (yield 64.1%)

### Synthesis Example 5-6. Synthesis of [Compound 28]

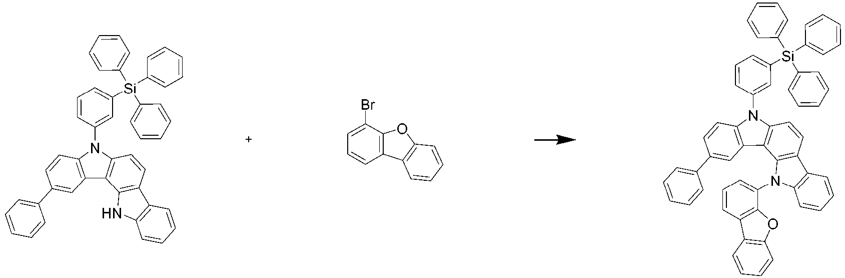

### <E-5> <E-6a> [Compound 28]

The same procedure as in Synthesis Example 1-2, with the exception of using <E-5> and <E-6a> instead of <A-1> and <A-2a>, was carried out to afford [Compound 28]. (yield 38.6%)
MS (MALDI-TOF) : m/z 832.29 [M ⁺]

### SYNTHESIS EXAMPLE 6. Synthesis of [Compound 37]

### Synthesis Example 6-1. Synthesis of F-1

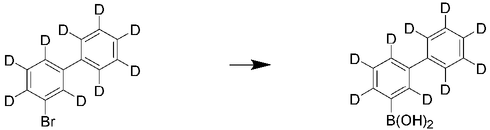

### <F-1a> <F-1>

In a round-bottom flask, a mixture of <F-1a> (60 g) and tetrahydrofuran (480 mL) was cooled to -78°C. N-butyl lithium (1.6M) (185.8 mL) was dropwise added and stirred for 2 hours while maintaining the temperature. Drops of trimethylborate (54.3 g) were slowly added and stirred for 12 hours at room temperature. After completion of the reaction, the reaction mixture was poured to water, stirred for 30 minutes, and subjected to layer separation with ethyl acetate and water. The organic layer thus obtained was dehydrated, concentrated at a reduced pressure, and dried in a vacuum to afford <F-1>. (43.2 g, yield 84.2%)

### Synthesis Example 6-2. Synthesis of <F-2>

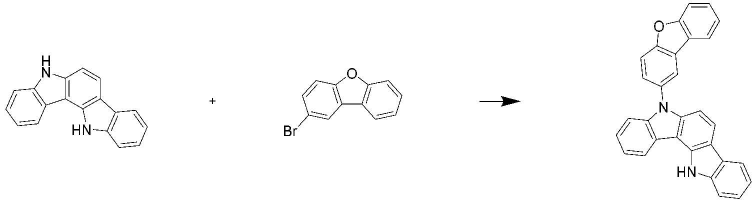

### <A-1a> <A-2a> <F-2>

The same procedure as in Synthesis Example 1-1, with the exception of using <A-2a> instead of <A-1b>, was carried out to afford <F-2>. (yield 68.2%)

### Synthesis Example 6-3. Synthesis of <F-3>

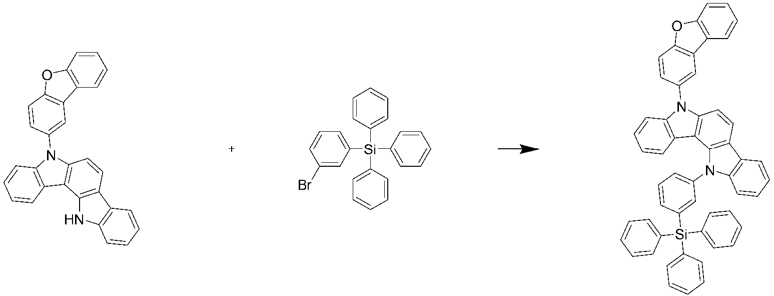

### <F-2> <A-1b> <F-3>

The same procedure as in Synthesis Example 1-2, with the exception of using <F-2> and <A-1b> instead of <A-1> and <A-2a>, respectively, was carried out to afford <F-3>. (yield 77.2%)

### Synthesis Example 6-4. Synthesis of <F-4>

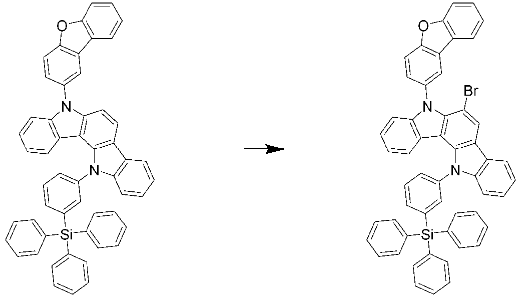

### <F-3> <F-4>

In a round-bottom flask, a mixture of <F-3> (18.6 g) and dichloromethane (190 mL) was cooled to 0°C. A solution of N-bromosuccinimide (5.9 g) in N,N-dimethylformamide (60 mL) was dropwise added and stirred for 8 hours. After completion of the reaction, the reaction mixture was warmed to room temperature, concentrated at a reduced pressure, and purified through column chromatography to afford <F-4>. (15 g, yield 73.2%)

### Synthesis Example 6-5. Synthesis of [Compound 37]

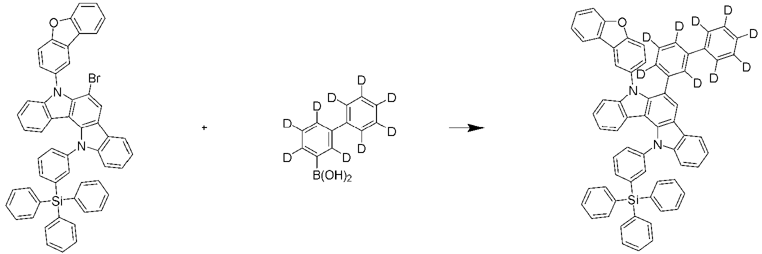

### <F-4> <F-1> [Compound 37]

The same procedure as in Synthesis Example 3-2, with the exception of using <F-4> and <F-1> instead of <C-1> and <C-2a>, respectively, was carried out to afford [Compound 37]. (yield 46.2%)
MS (MALDI-TOF) : m/z 917.38 [M⁺]

### SYNTHESIS EXAMPLE 7. Synthesis of [Compound 45]

### Synthesis Example 7-1. Synthesis of G-1

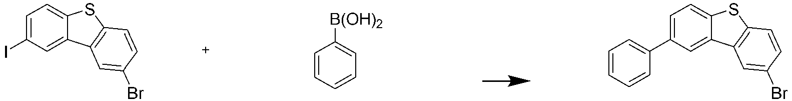

### <G-1a> <C-1b> <G-1>

The same procedure as in Synthesis Example 3-1, with the exception of using <G-1a> instead of <C-1a>, was carried out to afford <G-1>. (yield 44.9%)

### Synthesis Example 7-2. Synthesis of [Compound 45]

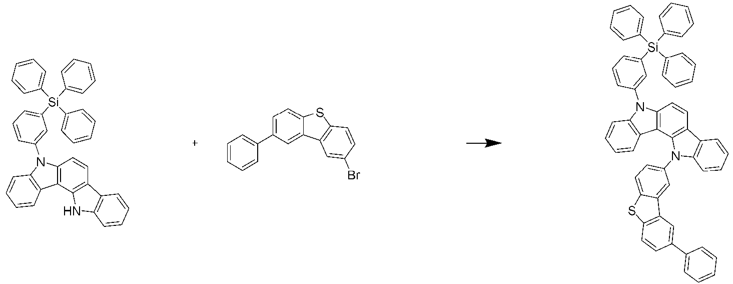

### <A-1> <G-1> [Compound 45]

The same procedure as in Synthesis Example 1-2, with the exception of using <G-1> instead of <A-2a>, was carried out to afford [Compound 45]. (yield 44.3%)
MS (MALDI-TOF) : m/z 848.27 [M ⁺]

### SYNTHESIS EXAMPLE 8. [Compound 58]

### Synthesis Example 8-1. Synthesis of H-1

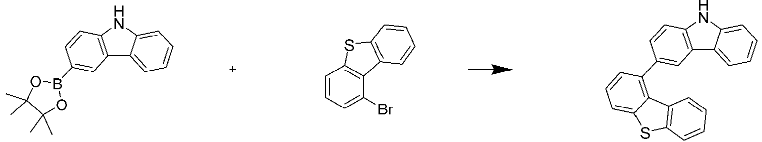

### <H-1a> <H-2a> <H-1>

The same procedure as in Synthesis Example 3-1, with the exception of using <H-2a> and <H-1a> instead of <C-1a> and <C-1b>, was carried out to afford <H-1>. (yield 61.1%)

### Synthesis Example 8-2. Synthesis of H-2

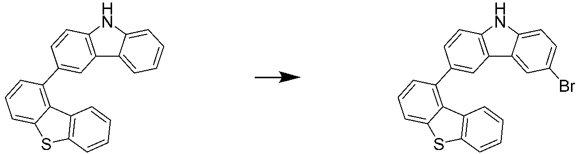

### <H-1> <H-2>

The same procedure as in Synthesis Example 5-1, with the exception of using <H-1> instead of <E-1a>, was carried out to afford <H-2>. (yield 83.2%)

### Synthesis Example 8-3. Synthesis of H-3

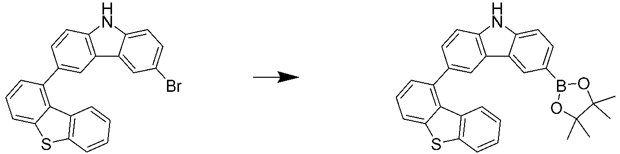

### <H-2> <H-3>

The same procedure as in Synthesis Example 5-2, with the exception of using <H-2> instead of <E-1>, was carried out to afford <H-3>. (yield 79.6%)

### Synthesis Example 8-4. Synthesis of H-4

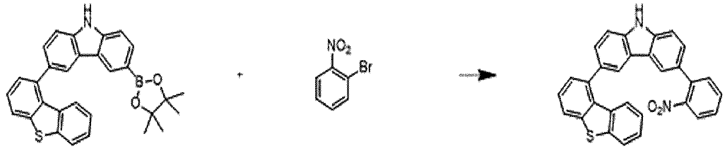

### <H-3> <E-3a> <H-4>

The same procedure as in Synthesis Example 3-2, with the exception of using <H-3> and <E-3a> instead of <C-1> and <C-2a>, respectively, was carried out to afford <H-4>. (yield 51.3%)

### Synthesis Example 8-5. Synthesis of <H-5>

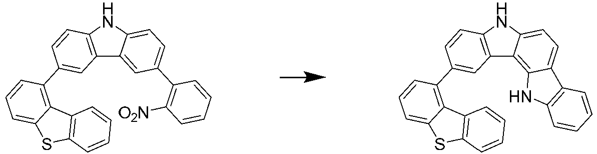

### <H-4> <H-5>

The same procedure as in Synthesis Example 5-4, with the exception of using <H-4> instead of <E-3>, was carried out to afford <H-5>. (yield 63.7%)

### Synthesis Example 8-6. Synthesis of <H-6>

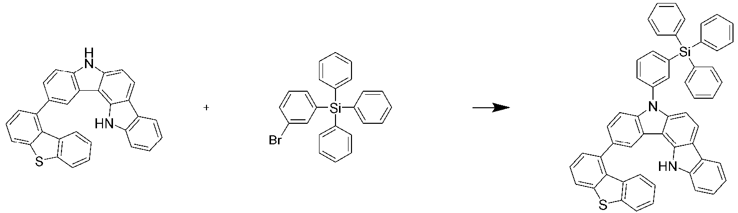

### <H-5> <A-1b> <H-6>

The same procedure as in Synthesis Example 1-1, with the exception of using <H-5> instead of <A-1a>, was carried out to afford <H-6>. (yield 61%)

### Synthesis Example 8-7. Synthesis of [Compound 58]

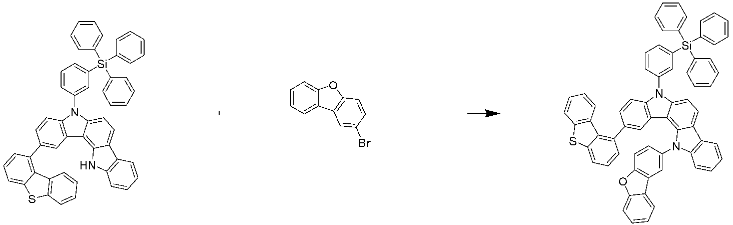

### <H-6> <A-2a> [Compound 58]

The same procedure as in Synthesis Example 1-2, with the exception of using <H-6> instead of <A-1>, was carried out to afford [Compound 58]. (yield 39.2%)
MS (MALDI-TOF) : m/z 938.28 [M ⁺]

### SYNTHESIS EXAMPLE 9. Synthesis of [Compound 64]

### Synthesis Example 9-1. Synthesis of I-1

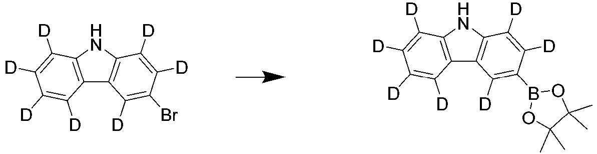

### <I-1a> <I-1>

The same procedure as in Synthesis Example 5-2, with the exception of using <I-1a> instead of <E-1>, was carried out to afford <I-1>. (yield 83.2%)

### Synthesis Example 9-2. Synthesis of I-2

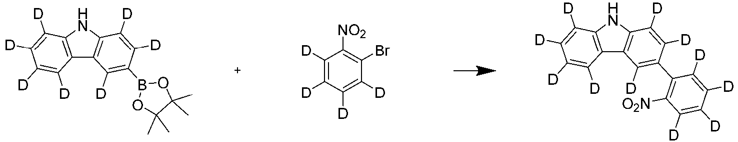

### <I-1> <I-2a> <I-2>

The same procedure as in Synthesis Example 5-3, with the exception of using <I-1> and <I-2a> instead of <E-2> and <E-3a>, respectively, was carried out to afford <I-2>. (yield 60.8%)

### Synthesis Example 9-3. Synthesis of I-3

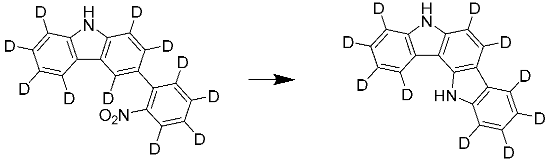

### <I-2> <I-3>

The same procedure as in Synthesis Example 5-4, with the exception of using <I-2> instead of <E-3>, was carried out to afford <I-3>. (yield 68.3%)

### Synthesis Example 9-4. Synthesis of I-4

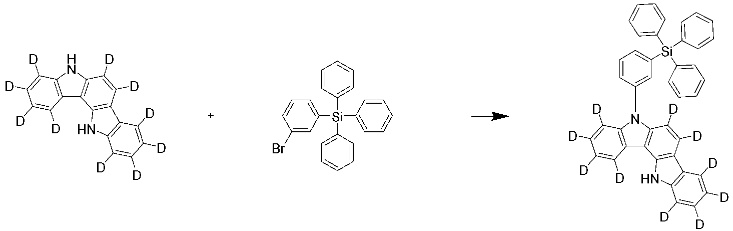

### <I-3> <A-1b> <I-4>

The same procedure as in Synthesis Example 1-1, with the exception of using <I-3> instead of <A-1a>, was carried out to afford <I-4>. (yield 65.3%)

### Synthesis Example 9-5. Synthesis of [Compound 64]

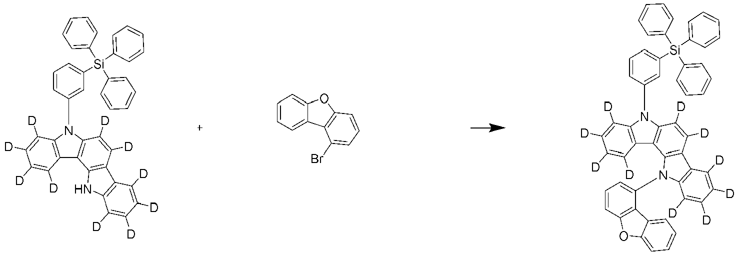

### <I-4> <I-5a> [Compound 64]

The same procedure as in Synthesis Example 1-2, with the exception of using <I-4> and <I-5a> instead of <A-1> and <A-2a>, respectively, was carried out to afford [Compound 64]. (yield 42.3%)
MS (MALDI-TOF) : m/z 766.32 [M ⁺]

### SYNTHESIS EXAMPLE 10. [Compound 70]

### Synthesis Example 10-1. Synthesis of J-1

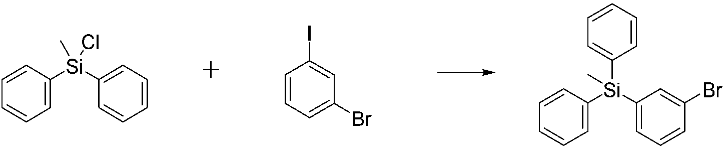

### <J-1a> <J-1b> <J-1>

In a round-bottom flask, a mixture of <J-1b> (50 g) and THF (500 mL) was cooled to -78°C under a nitrogen atmosphere, followed by slow addition of drops of 1.6 M n-butyl lithium (121.51 mL). The mixture was stirred for 1 hour and a dilution of <J-1b> in THF (308 mL) was slowly added. Stirring was conducted for 1 hour at -78°C and at room temperature for 12 hours. After completion of the reaction, the reaction was subjected to extraction with water. The organic layer thus obtained was concentrated at a reduced pressure and isolated by column chromatography to afford <J-1>. (43.7 g, 70%)

### Synthesis Example 10-2. Synthesis of J-2

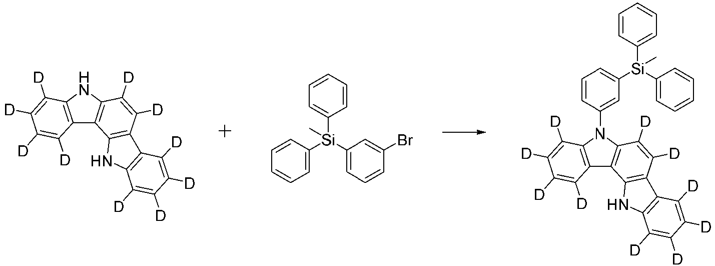

### <I-3> <J-1> <J-2>

The same procedure as in Synthesis Example 1-1, with the exception of using <I-3> and <J-1> instead of <A-1a> and <A-1b>, respectively, was carried out to afford <J-2>. (yield65%)

### Synthesis Example 10-3. Synthesis of [Compound 70]

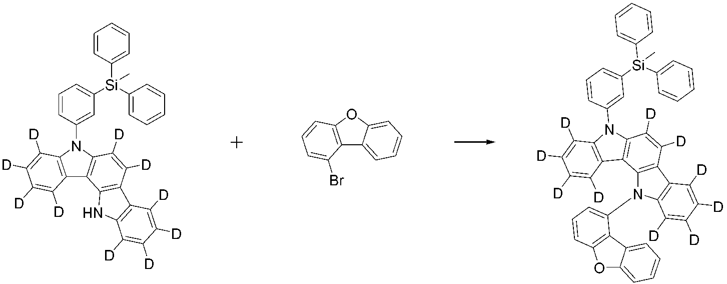

### <J-2> <I-5a> [Compound 70]

The same procedure as in Synthesis Example 1-2, with the exception of using <J-2> and <I-5a> instead of <A-1> and <A-2a>, respectively, was carried out to afford [Compound 70]. (yield 68.3%)
MS (MALDI-TOF) : m/z 704.31 [M⁺]

### SYNTHESIS EXAMPLE 11. Synthesis of [Compound 71]

### Synthesis Example 11-1. Synthesis of K-1

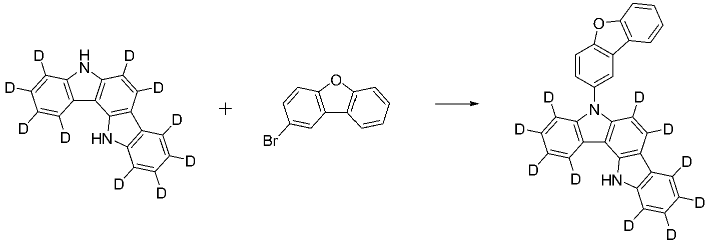

### <I-3> <A-2a> <K-1>

The same procedure as in Synthesis Example 1-1, with the exception of using <I-3> and <A-2a> instead of <A-1a> and <A-1b>, respectively, was carried out to afford <K-1>. (yield 65.2%)

### Synthesis Example 11-2. Synthesis of K-2

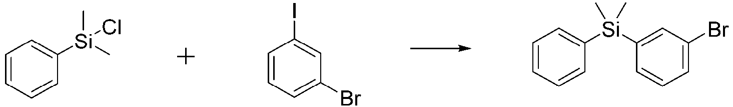

### <K-2a> <J-1b> <K-2>

The same procedure as in Synthesis Example 10-1, with the exception of using <K-2a> instead of <J-1a>, was carried out to afford <K-2>. (yield 67%)

### Synthesis Example 11-3. Synthesis of [Compound 71]

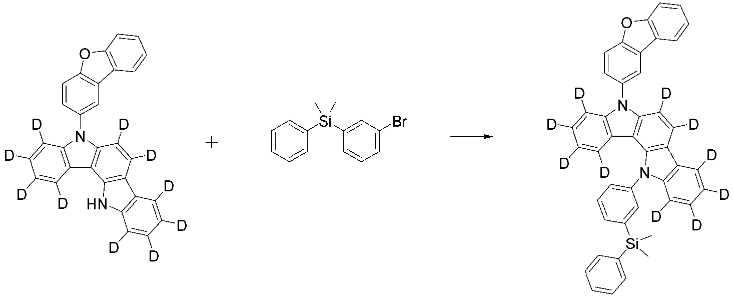

### <K-1> <K-2> [Compound 71]

The same procedure as in Synthesis Example 1-2, with the exception of using <K-1> and <K-2> instead of <A-1> and <A-2a>, respectively, was carried out to afford [Compound 71]. (yield 67.4%)
MS (MALDI-TOF) : m/z 642.29 [M ⁺]

### SYNTHESIS EXAMPLE 12. Synthesis of [Compound 72]

### Synthesis Example 12-1. Synthesis of L-1

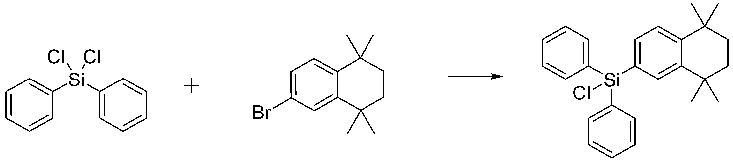

### <L-1a> <L-1b> <L-1>

The same procedure as in Synthesis Example 10-1, with the exception of using <L-1a> and <L-1b> instead of <J-1a> and <J-1b>, respectively, was carried out to afford <L-1>. (yield60%)

### Synthesis Example 12-2. Synthesis of L-2

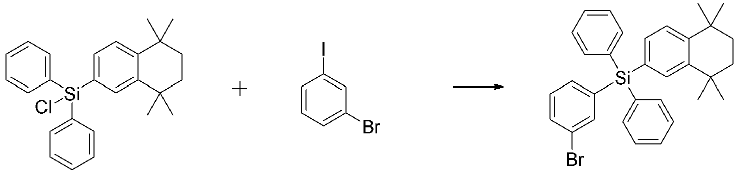

### <L-1> <J-1b> <L-2>

The same procedure as in Synthesis Example 10-1, with the exception of using <L-1> instead of <J-1a>, was carried out to afford <L-2>. (yield 65%)

### Synthesis Example 12-3. Synthesis of L-3

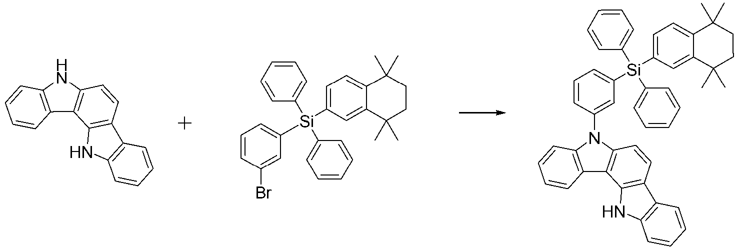

### <A-1a> <L-2> <L-3>

The same procedure as in Synthesis Example 1-1, with the exception of using <L-2> instead of <A-1b>, was carried out to afford <L-3>. (yield 66%)

### Synthesis Example 12-4. Synthesis of [Compound 72]

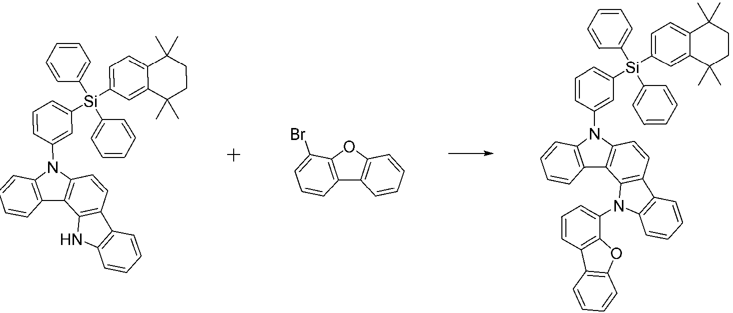

### <L-3> <E-6a> [Compound 72]

The same procedure as in Synthesis Example 1-2, with the exception of using <L-3> and <E-6a> instead of <A-1> and <A-2a>, respectively, was carried out to afford [Compound 72]. (yield 71%)
MS (MALDI-TOF) : m/z 866.37 [M ⁺]

### EXAMPLES 1 TO 12 : Fabrication of Organic Light-Emitting Diodes

An ITO glass substrate was patterned to have a translucent area of 2 mm x 2 mm and cleansed. The ITO glass was mounted in a vacuum chamber that was then set to have a base pressure of 1x10⁻⁶ torr. On the ITO glass substrate, HAT-CN (50 Å) and BCFN (600 Å) were sequentially deposited to form a hole injection layer and a hole transport layer, respectively, followed by forming a film of PBCz (50 Å) as an electron blocking layer. As an emission layer, a film (350 Å) was formed from the first and second host compounds according to the present disclosure, with the following PBD serving as a dopant compound in an amount of 12 wt% based on the total weight of the emission layer. A hole blocking layer was made of mSiTrz (50 Å). Thereafter, films were sequentially formed from a mixture of 1:1 of mSiTrz : Liq (300 Å) for an electron injection and transport layer (300 Å), Liq for an electron injection layer (10 Å), and Al for a cathode (1000 Å), thereby fabricating an organic light-emitting diode. The organic light-emitting diodes thus obtained were measured at 0.4 mA for luminescence properties:

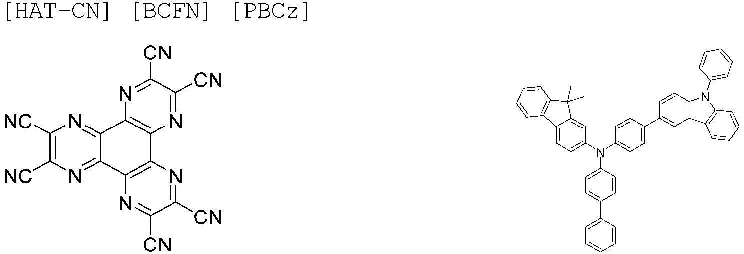

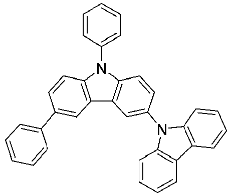

[000474] 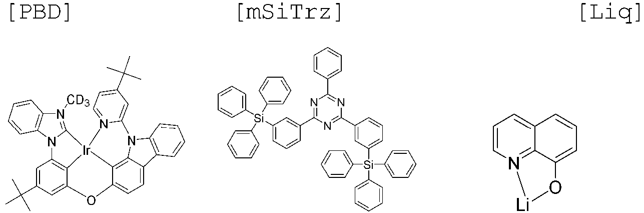 [000476]

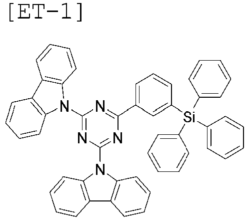

### COMPARATIVE EXAMPLES 1 TO 6

Organic light-emitting diodes for the Comparative Examples were fabricated in the same manner as in the Examples, with the exception of using the following [RH-1] to [RH-6], instead of the compounds according to the present disclosure, as hosts in the diodes of the Examples. The organic light-emitting diodes thus obtained were measured at 0.4 mA for luminescence properties. Here, the structures of [RH-1] to [RH-6] are as follows:

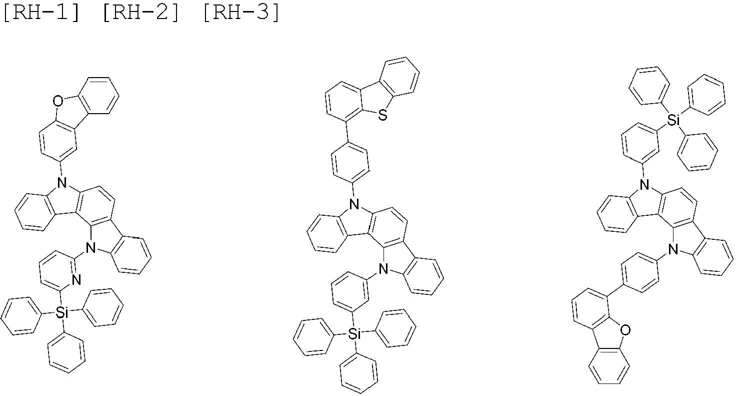

[000483]

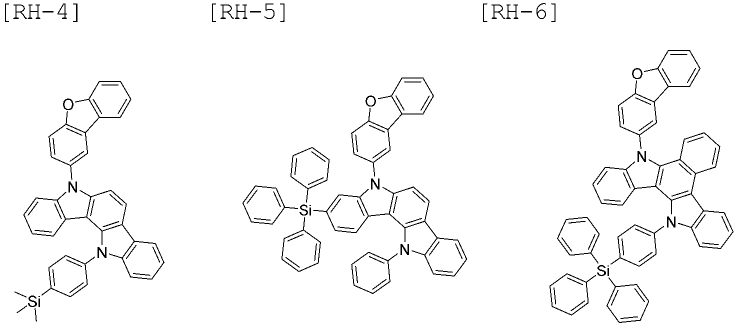

**[TABLE 1]**

| Ex. No. | Host (1:1) | | Driving Volt. (V) | External Quantum Effici. (EQE, %) | Lifetime (T95, hr) | Luminescence (color) |
|---|---|---|---|---|---|---|
| Ex. 1 | Cpd. 2 | ET-1 | 3.9 | 16.7 | 182 | Blue |
| Ex. 2 | Cpd. 11 | ET-1 | 3.9 | 17.0 | 140 | Blue |
| Ex. 3 | Cpd. 15 | ET-1 | 4.2 | 16.5 | 144 | Blue |
| Ex. 4 | Cpd. 20 | ET-1 | 4.0 | 17.2 | 168 | Blue |
| Ex. 5 | Cpd. 28 | ET-1 | 4.1 | 17.0 | 187 | Blue |
| Ex. 6 | Cpd. 37 | ET-1 | 4.0 | 16.4 | 169 | Blue |
| Ex. 7 | Cpd. 45 | ET-1 | 4.1 | 16.1 | 158 | Blue |
| Ex. 8 | Cpd. 58 | ET-1 | 4.2 | 16.5 | 131 | Blue |
| Ex. 9 | Cpd. 64 | ET-1 | 4.0 | 16.9 | 205 | Blue |
| Ex. 10 | Cpd. 70 | ET-1 | 3.9 | 16.6 | 173 | Blue |
| Ex. 11 | Cpd. 71 | ET-1 | 4.0 | 16.8 | 180 | Blue |
| Ex. 12 | Cpd. 72 | ET-1 | 4.1 | 17.0 | 186 | Blue |
| C. Ex. 1 | RH-1 | ET-1 | 5.1 | 11.7 | 65 | Blue |
| C. Ex. 2 | RH-2 | ET-1 | 4.5 | 8.1 | 84 | Blue |
| C. Ex. 3 | RH-3 | ET-1 | 4.6 | 7.7 | 73 | Blue |
| C. Ex. 4 | RH-4 | ET-1 | 4.5 | 7.5 | 70 | Blue |
| C. Ex. 5 | RH-5 | ET-1 | 4.7 | 7.6 | 72 | Blue |
| C. Ex. 6 | RH-6 | ET-1 | 5.1 | 8.1 | 74 | Blue |

As shown in Table 1, the organic light-emitting diodes employing the compounds according to the present disclosure as hosts in the emission layers thereof exhibited high efficiency and long lifetime characteristics, with improved luminous efficiency and lifetime at lower driving voltages, in comparison to the organic light-emitting diodes employing conventional comparative compounds (Comparative Examples 1 to 6) having characteristic structures contrast to the compounds according to the present disclosure.

### EXAMPLES 13 TO 24: Fabrication of Organic Light-Emitting Diodes

Organic light-emitting diodes are fabricated in the same manner as in Examples 1 to 12, with the exception that the following TBD compound was as an additional dopant in an amount of 0.5 wt% based on the total weight of the emission layer. The organic light-emitting diodes thus obtained were measured at 0.4 mA for luminescence properties and the measurements are given in Table 2, below. The structure of [TBD] is as follows:

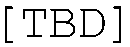

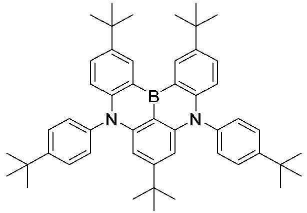

### COMPARATIVE EXAMPLES 7 TO 12

Organic light-emitting diodes for the Comparative Examples were fabricated in the same manner as in the Examples, with the exception of using [RH-1] to [RH-6], instead of the compounds according to the present disclosure, as host compounds. The organic light-emitting diodes thus obtained were measured at 0.4 mA for luminescence properties.

**[TABLE 2]**

| Ex. No. | Host (1:1) | | Driving Volt. (V) | External Quantum Effici. (EQE, %) | Lifetime (T95, hr) | Luminescence (color) |
|---|---|---|---|---|---|---|
| Ex. 13 | Cpd. 2 | ET-1 | 4.1 | 17.1 | 201 | Blue |
| Ex. 14 | Cpd. 11 | ET-1 | 4.1 | 17.2 | 159 | Blue |
| Ex. 15 | Cpd. 15 | ET-1 | 4.5 | 16.8 | 171 | Blue |
| Ex. 16 | Cpd. 20 | ET-1 | 4.3 | 17.6 | 188 | Blue |
| Ex. 17 | Cpd. 28 | ET-1 | 4.4 | 17.2 | 208 | Blue |
| Ex. 18 | Cpd. 37 | ET-1 | 4.2 | 16.8 | 184 | Blue |
| Ex. 19 | Cpd. 45 | ET-1 | 4.5 | 16.6 | 173 | Blue |
| Ex. 20 | Cpd. 58 | ET-1 | 4.6 | 17.0 | 163 | Blue |
| Ex. 21 | Cpd. 64 | ET-1 | 4.4 | 17.0 | 224 | Blue |
| Ex. 22 | Cpd. 70 | ET-1 | 4.1 | 17.0 | 192 | Blue |
| Ex. 23 | Cpd. 71 | ET-1 | 4.2 | 17.2 | 199 | Blue |
| Ex. 24 | Cpd. 72 | ET-1 | 4.3 | 17.4 | 205 | Blue |
| C. Ex. 7 | RH-1 | ET-1 | 5.3 | 12.1 | 84 | Blue |
| C. Ex. 8 | RH-2 | ET-1 | 4.7 | 8.5 | 103 | Blue |
| C. Ex. 9 | RH-3 | ET-1 | 4.8 | 8.1 | 92 | Blue |
| C. Ex. 10 | RH-4 | ET-1 | 4.7 | 7.9 | 89 | Blue |
| C. Ex. 11 | RH-5 | ET-1 | 4.9 | 8.0 | 91 | Blue |
| C. Ex. 12 | RH-6 | ET-1 | 5.3 | 8.5 | 93 | Blue |

As shown in Table 2, the organic light-emitting diodes employing the compounds according to the present disclosure as hosts in the emission layers thereof exhibited high efficiency and long lifetime characteristics, with improved luminous efficiency and lifetime at lower driving voltages, in comparison to the organic light-emitting diodes employing conventional comparative compounds (Comparative Examples 7 to 12) having characteristic structures contrast to the compounds according to the present disclosure.

### EXAMPLES 25 TO 28 : Fabrication of Organic Light-Emitting Diodes

Organic light-emitting diodes are fabricated in the same manner as in Examples 1 to 12, with the exception that the heterocyclic compounds according to the present disclosure were used alone as a host in the emission layer. The organic light-emitting diodes thus obtained were measured at 0.4 mA for luminescence properties and the measurements are given in Table 3, below.

### COMPARATIVE EXAMPLE 13

Organic light-emitting diodes for the Comparative Examples were fabricated in the same manner as in the Examples, with the exception of using RH-2, instead of the compounds according to the present disclosure, as a host. The organic light-emitting diodes thus obtained were measured at 0.4 mA for luminescence properties and the measurements are given in Table 3, below.

**[TABLE 3]**

| Ex. No. | Host | Driving Volt. (V) | External Quantum Effici. (EQE, %) | Lifetime (T95, hr) | Luminescence (color) |
|---|---|---|---|---|---|
| Ex. 25 | Cpd. 2 | 5.6 | 7.8 | 91 | Blue |
| Ex. 26 | Cpd. 20 | 5.8 | 9.1 | 85 | Blue |
| Ex. 27 | Cpd. 28 | 5.8 | 8.3 | 82 | Blue |
| Ex. 28 | Cpd. 64 | 5.9 | 8.2 | 101 | Blue |
| C. Ex. 13 | RH-2 | 6.5 | 5.6 | 48 | Blue |

As shown in Table 3, the organic light-emitting diodes employing the compounds according to the present disclosure as host compounds in the emission layer thereof exhibited high efficiency and long lifetime characteristics, with improved luminous efficiency and lifetime at lower driving voltages, in comparison to the organic light-emitting diodes employing the conventional comparative compound (Comparative Example 13) having characteristic structures contrast to the compounds according to the present disclosure.

### Industrial Applicability

When the heterocyclic compound according to the present disclosure is used as a phosphorescent host material in the light-emitting layer of an organic light-emitting diode, the organic light-emitting diode exhibits lower driving voltage, higher efficiency, and longer lifespan, compared to organic light-emitting devices according to conventional technologies. Therefore, it has high industrial applicability in fields such as organic light-emitting devices and displays.

## Claims

1. A heterocyclic compound represented by the following Chemical Formula 1: 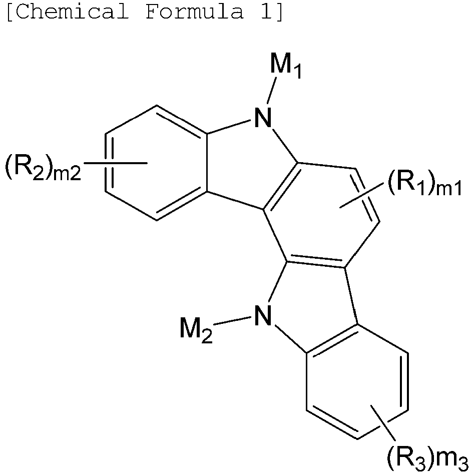 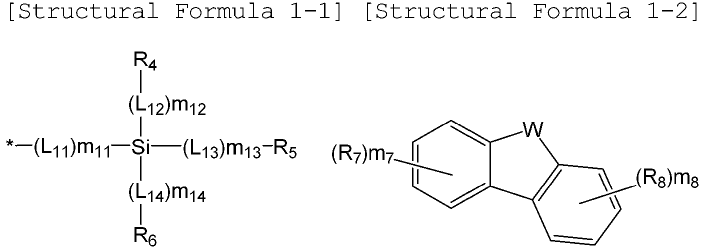 wherein,
M₁ and M₂ are each a substituent represented by Structural Formula 1-1 or Structural Formula 1-2, provided that M1 and M2 are not both represented by Structural Formula 1-1 or both represented by Structural Formula 1-2,
"*" in Structural Formula 1-1 means a bonding site to any one of the two nitrogen atoms (N) in Chemical Formula 1,
any one of the multiple substituents R₇ in Structural Formula 1-2 is a single bond to a nitrogen atom (N) other than the nitrogen atom bonded to the moiety of Structural Formula 1-1 among the two nitrogen atoms (N) of Chemical Formula 1,
the substituents R₁ to R₃, the substituent R₇ except for the single bond connected to any one of the two nitrogen atoms in Chemical Formula 1, and the substituent R₈, which are same or different, are each independently any one selected from a hydrogen atom, a deuterium atom, a tritium atom, a substituted or unsubstituted alkyl of 1 to 30 carbon atoms, a substituted or unsubstituted halogenated alkyl of 1 to 30 carbon atoms, a substituted or unsubstituted alkenyl of 2 to 30 carbon atoms, a substituted or unsubstituted alkynyl of 2 to 30 carbon atoms, a substituted or unsubstituted aryl of 6 to 50 carbon atoms, a substituted or unsubstituted cycloalkyl of 3 to 30 carbon atoms, a substituted or unsubstituted cycloalkenyl of 5 to 30 carbon atoms, a substituted or unsubstituted heterocycloalkyl of 2 to 30 carbon atoms, a substituted or unsubstituted heteroalkyl of 2 to 50 carbon atoms, a substituted or unsubstituted heteroaryl of 2 to 50 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted alkoxy of 1 to 30 carbon atoms, a substituted or unsubstituted aryloxy of 6 to 30 carbon atoms, a substituted or unsubstituted cycloalkyloxy of 3 to 30 carbon atoms, a substituted or unsubstituted heteroaryloxy of 2 to 30 carbon atoms, a substituted or unsubstituted alkylthio of 1 to 30 carbon atoms, a substituted or unsubstituted arylthio of 6 to 30 carbon atoms, a substituted or unsubstituted cycloalkylthio of 3 to 30 carbon atoms, a substituted or unsubstituted heteroarylthio of 2 to 30 carbon atoms, a substituted or unsubstituted amine of 0 to 40 carbon atoms, a substituted or unsubstituted silyl of 0 to 40 carbon atoms, a germanium of 0 to 40 carbon atoms, a nitro, a cyano, and a halogen,
the substituents R₄ to R₆, which are same or different, are each independently any one selected from a substituted or unsubstituted alkyl of 1 to 30 carbon atoms, a substituted or unsubstituted aryl of 6 to 50 carbon atoms, a substituted or unsubstituted heteroaryl of 2 to 50 carbon atoms, a substituted or unsubstituted aliphatic hydrocarbon ring-fused aryl of 8 to 30 carbon atoms, and a substituted or unsubstituted aliphatic hydrocarbon ring-fused heteroaryl of 5 to 30 carbon atoms, with exception that all of R₄ to R₆ are a substituted or unsubstituted alkyl of 1 to 30 carbon atoms,
L₁₁ to L₁₄, which are same or different, are each independently a linker selected from a single bond, a substituted or unsubstituted arylene of 6 to 18 carbon atoms, a substituted or unsubstituted heteroarylene of 3 to 18 carbon atoms, and a substituted or unsubstituted aliphatic hydrocarbon ring-fused arylene of 8 to 20 carbon atoms,
adjacent substituents in each of the multiple R₇ and the multiple R₈ may be linked to additionally form a mono- or polycyclic aliphatic or aromatic ring,
m₁ is 2, wherein the corresponding substituents R₁ are same or different,
m₂ and m₃ are each 4, wherein the corresponding substituents R₂ and the corresponding substituents R₃ are respectively same or different,
m₁₁ to m₁₄ are each 1 or 2, wherein when m₁₁ is 2, the corresponding linkers L₁₁ are same or different, when m₁₂ is 2, the corresponding linkers L₁₂ are same or different, when m₁₃ is 2, the corresponding linkers L₁₃ are same or different, and when m₁₄ is 2, the corresponding linkers L₁₄ are same or different,
m₇ and m₈ are each 4, wherein the corresponding substituents R₇ and the corresponding substituents R₈ in the respective aromatic rings are same or different,
W in Structural Formula 1-2 is O or S,
wherein the term "substituted" in the expression "a substituted or unsubstituted" used for the compounds of Chemical Formula 1 and Structural Formulas 1-1 and 1-2 means having at least one substituent selected from the group consisting of a deuterium atom, a tritium atom, a cyano, a halogen, a hydroxy, a nitro, an alkyl of 1 to 30 carbon atoms, a halogenated alkyl of 1 to 30 carbon atoms, an alkenyl of 2 to 24 carbon atoms, an alkynyl of 2 to 24 carbon atoms, a cycloalkyl of 3 to 24 carbon atoms, a heteroalkyl of 1 to 24 carbon atoms, an aryl of 6 to 24 carbon atoms, an arylalkyl of 7 to 24 carbon atoms, an alkylaryl of 7 to 24 carbon atoms, a heteroaryl of 2 to 24 carbon atoms, a heteroarylalkyl of 3 to 24 carbon atoms, an alkylheteroaryl of 3 to 24 carbon atoms, an alkoxy of 1 to 24 carbon atoms, an aromatic hydrocarbon ring-fused cycloalkyl of 7 to 30 carbon atoms, a heteroaromatic ring-fused cycloalkyl of 5 to 30 carbon atoms, an aromatic hydrocarbon ring-fused heterocycloalkyl of 6 to 30 carbon atoms, an aliphatic hydrocarbon ring-fused aryl of 7 to 30 carbon atoms, an aliphatic hydrocarbon ring-fused heteroaryl of 5 to 30 carbon atoms, a substituted or unsubstituted heteroaliphatic ring-fused aryl of 6 to 30 carbon atoms, a substituted or unsubstituted heteroaliphatic ring-fused heteroaryl of 5 to 30 carbon atoms, an amine of 1 to 30 carbon atoms, a silyl of 1 to 30 carbon atoms, a germanium of 1 to 30 carbon atoms, an aryloxy of 6 to 24 carbon atoms, and an arylthionyl of 6 to 24 carbon atoms, with at least one hydrogen atom on the substituent being substitutable with a deuterium or tritium atom.

2. The heterocyclic compound of claim 1, wherein the compound represented by Chemical Formula 1 comprises at least one deuterium atom.

3. The heterocyclic compound of claim 2, wherein at least one of R₁ to R₃ comprises a deuterium atom.

4. The heterocyclic compound of claim 3, wherein R₁ to R₃ are each a deuterium atom.

5. The heterocyclic compound of claim 1,
wherein m₁₁ to m₁₄ are each 1,
L₁₁ to L₁₄ are same or different and are each independently a single bond or a substituted or unsubstituted arylene of 6 to 12 carbon atoms.

6. The heterocyclic compound of claim 1,
wherein R₄ to R₆ are same or different and are each independently any one selected from a substituted or unsubstituted aryl of 6 to 18 carbon atoms, a substituted or unsubstituted heteroaryl of 2 to 18 carbon atoms, and a substituted or unsubstituted aliphatic hydrocarbon ring-fused aryl of 8 to 20 carbon atoms.

7. The heterocyclic compound of claim 1,
wherein the substituents R₇ and R₈ are each a deuterium atom.

8. The heterocyclic compound of claim 1,
wherein W in Structural Formula 1-2 is an oxygen atom (O).

9. The heterocyclic compound of claim 1,
wherein the compound represented by Chemical Formula 1 is one selected from the group consisting of the compounds represented by 1 to 87, below:

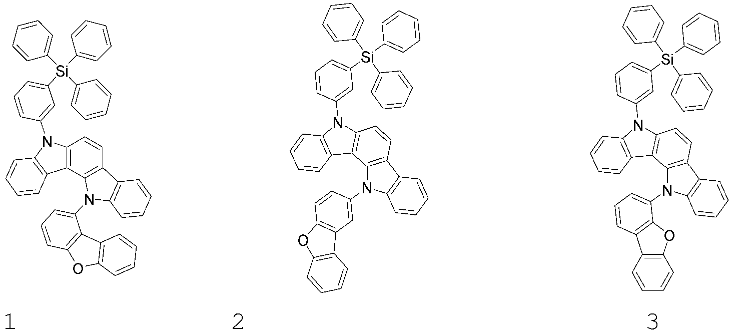

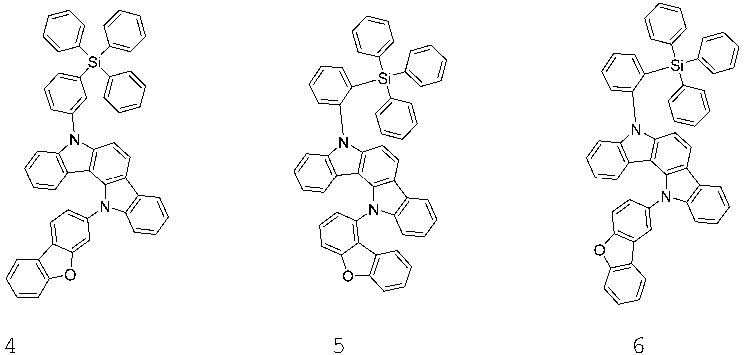

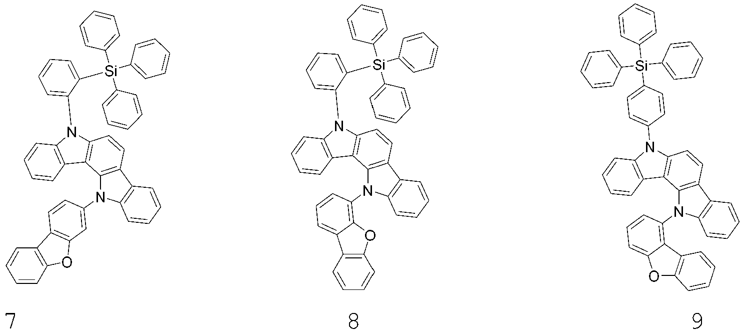

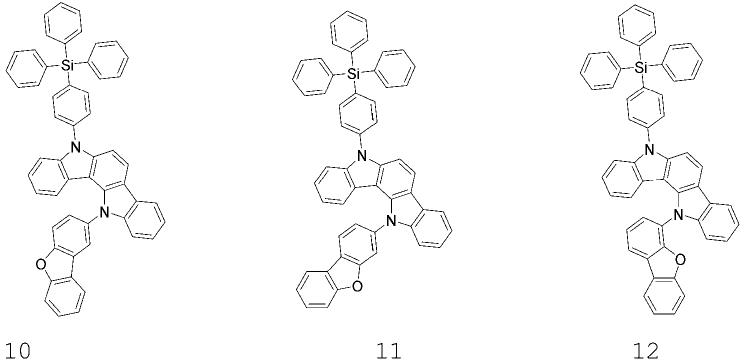

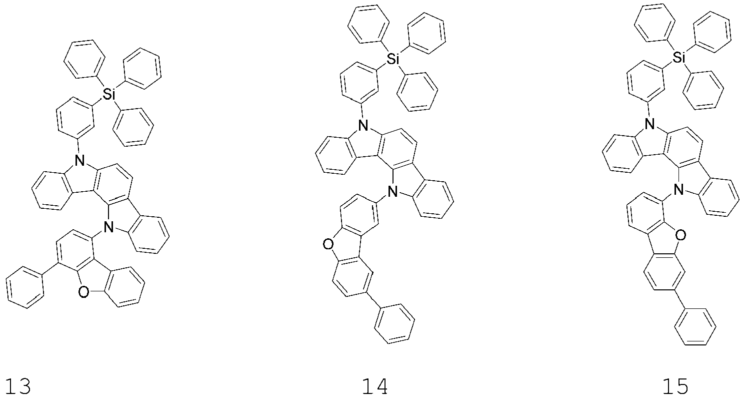

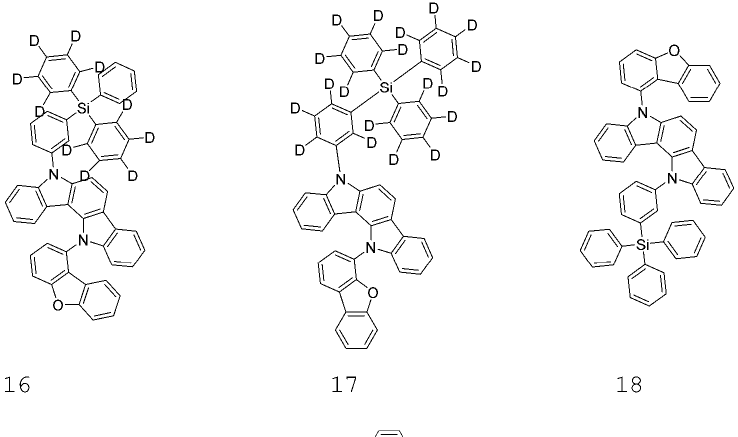

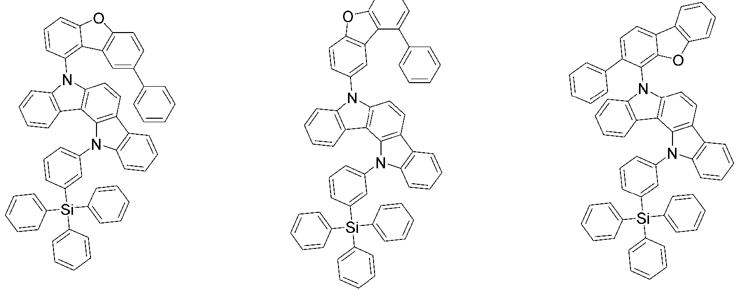

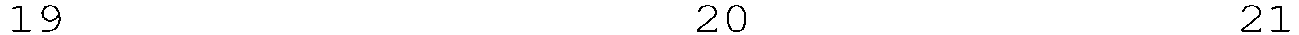

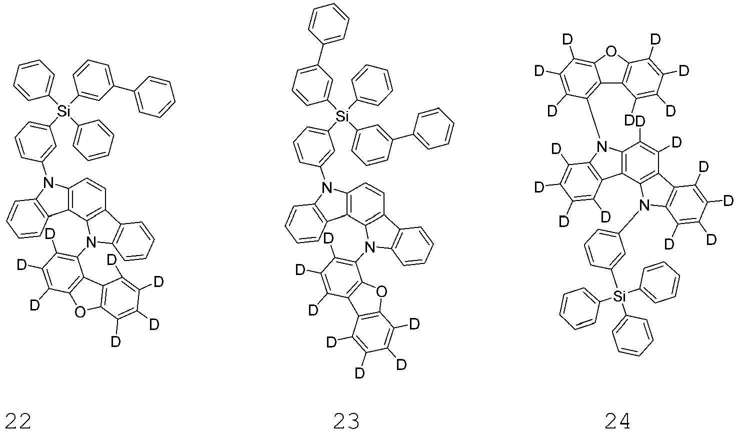

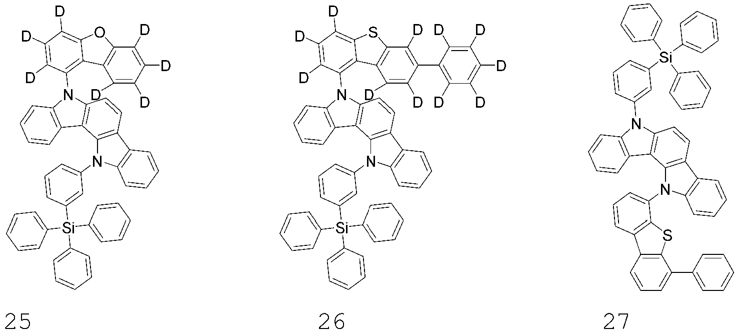

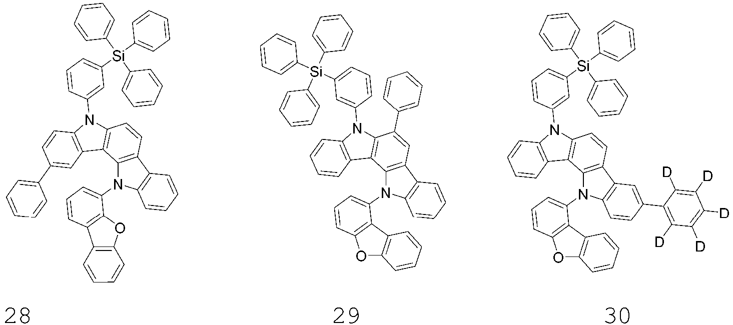

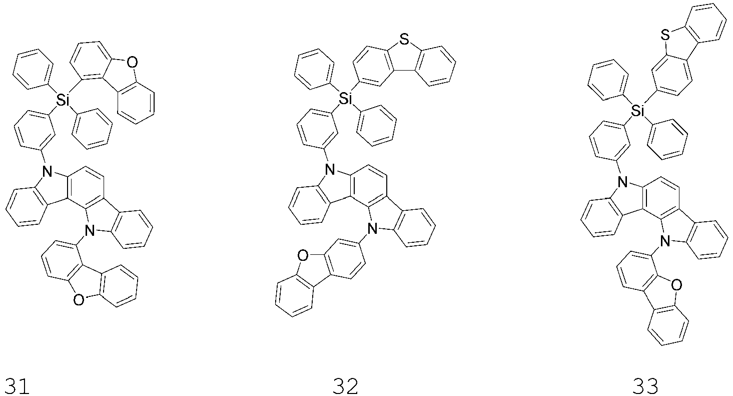

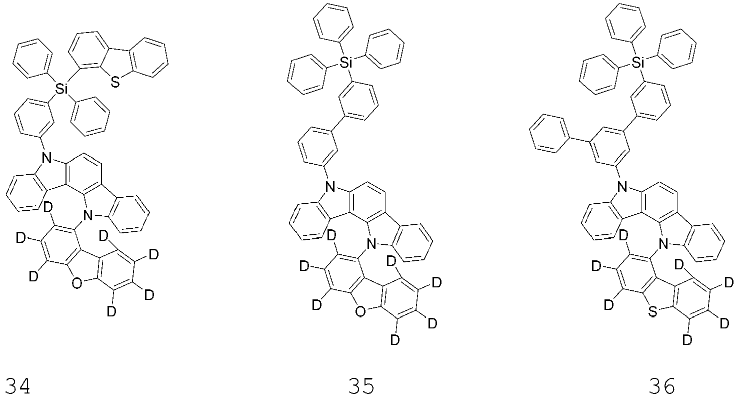

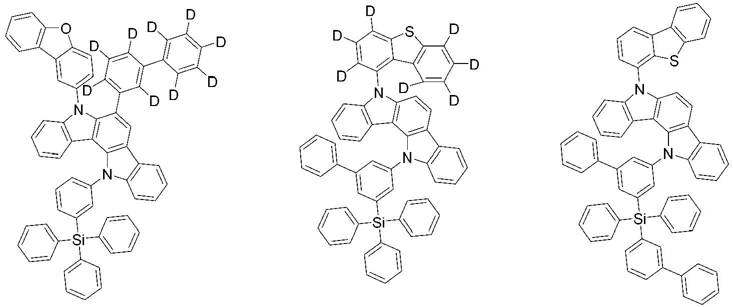

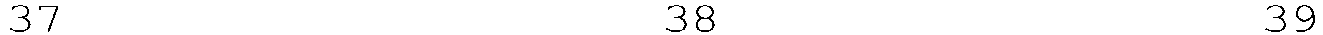

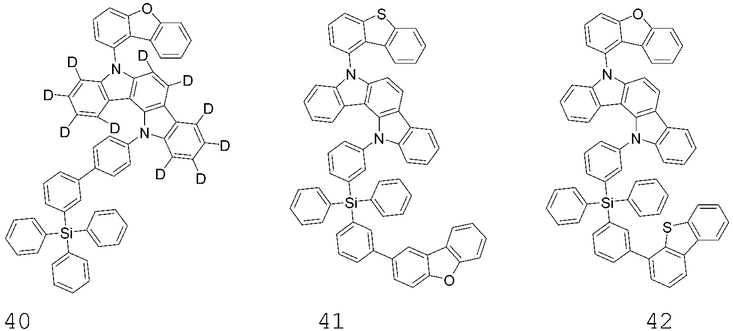

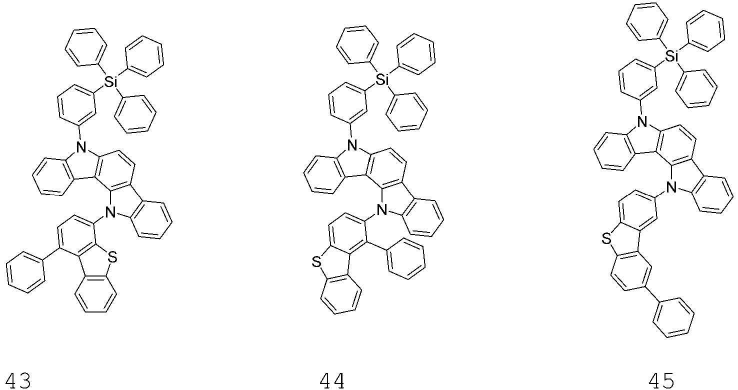

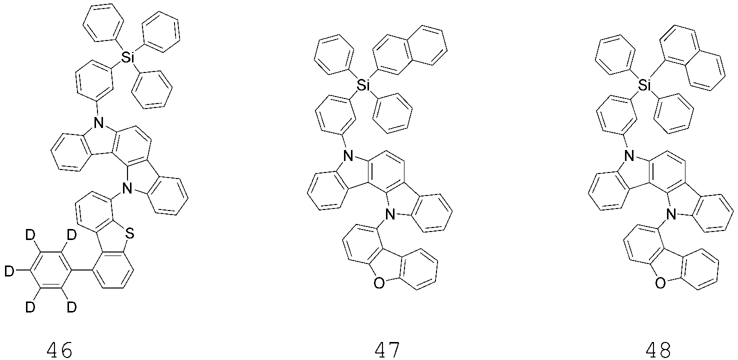

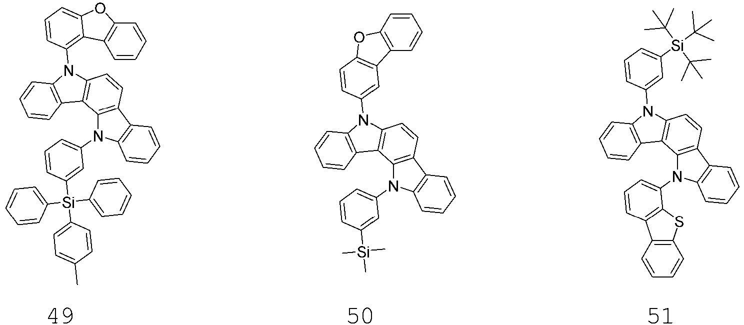

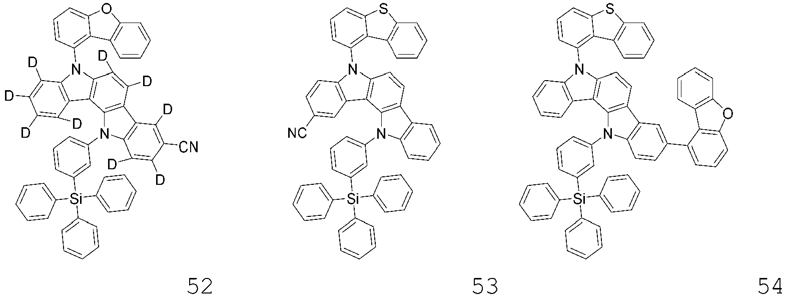

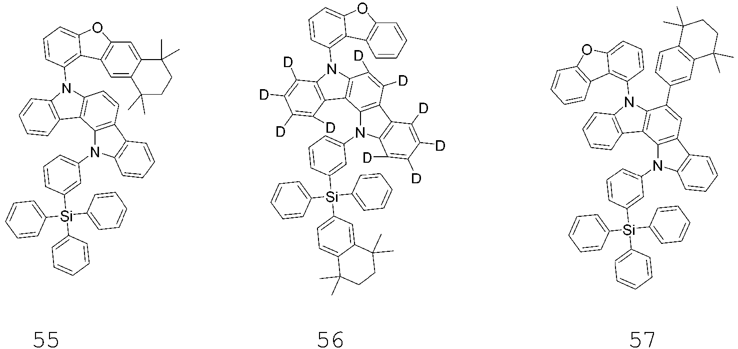

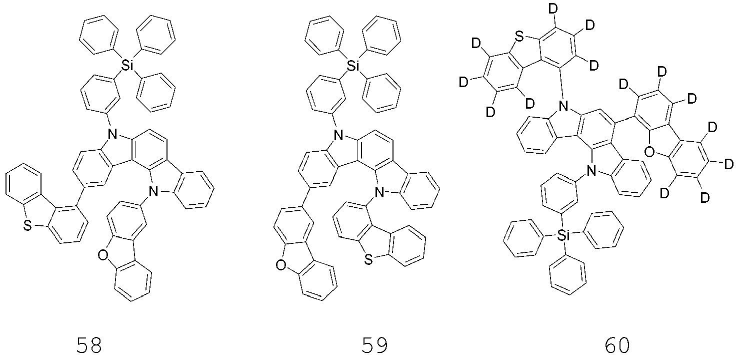

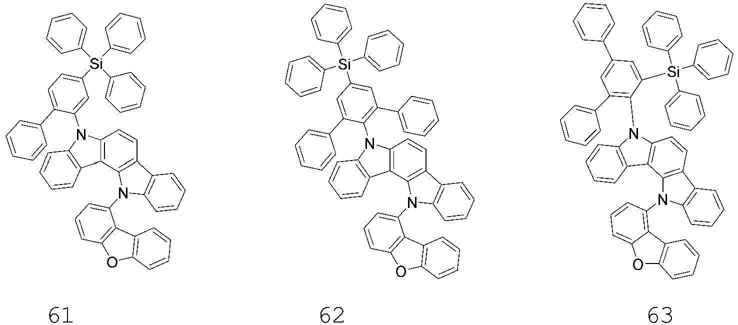

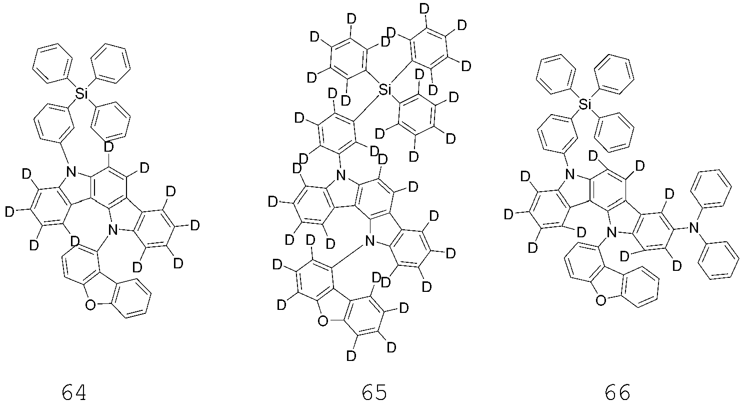

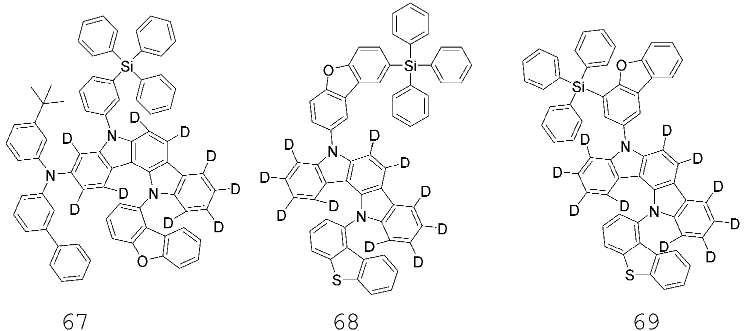

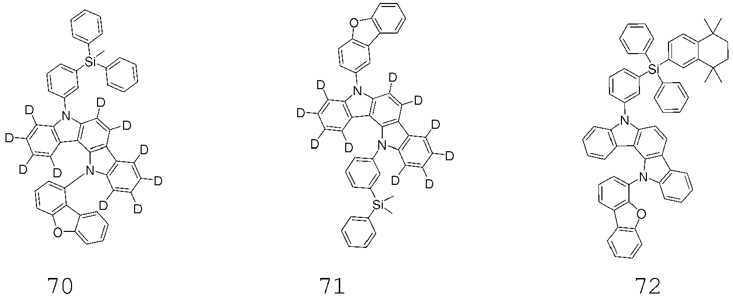

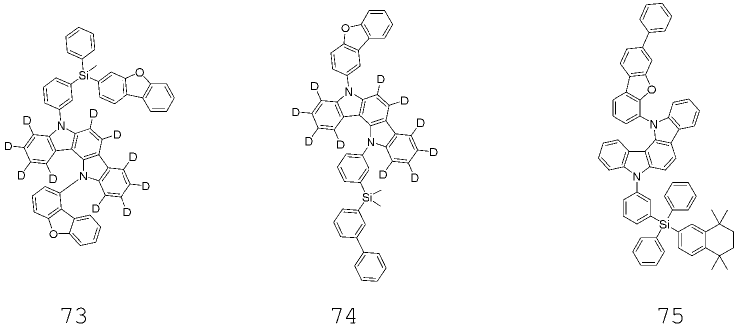

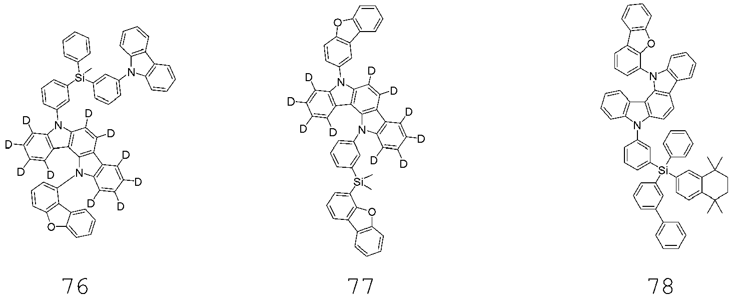

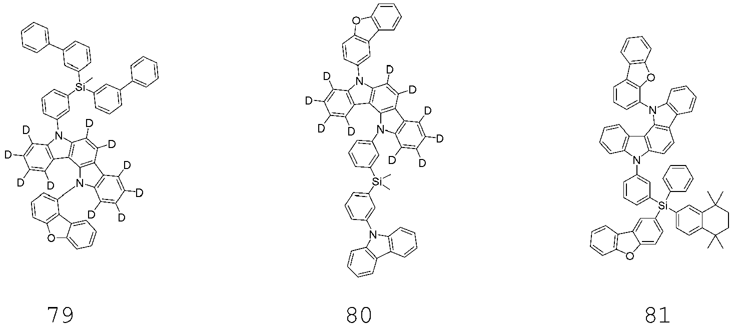

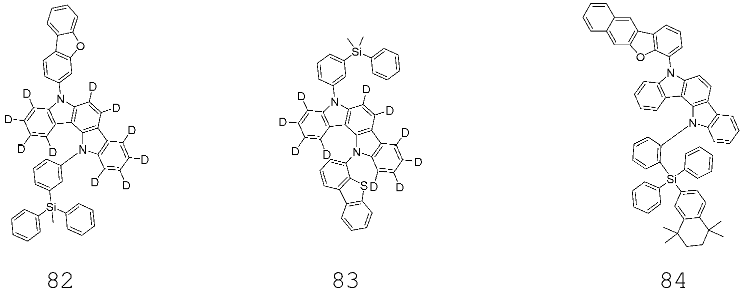

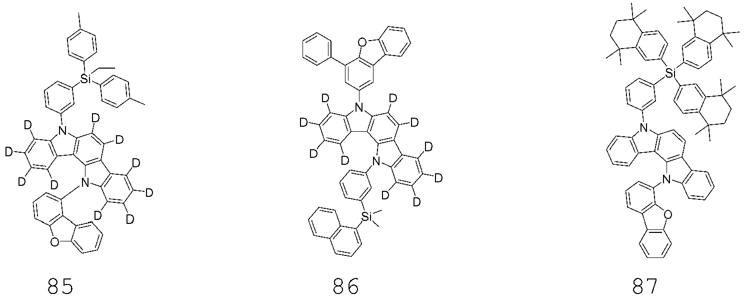

10. An organic light-emitting diode comprising:
a first electrode;
a second electrode facing the first electrode;
an organic layer interposed between the first electrode and the second electrode
wherein the organic layer comprises an emission layer containing a host and a dopant therein and the host comprises at least one of the heterocyclic compounds as set forth in claims 1 to 9.

11. The organic light-emitting diode of claim 10, wherein the emission layer of the organic light-emitting diode further comprises a host compound different from the heterocyclic compound, the host compound and the heterocyclic compound being used in mixture or stacked.

12. The organic light-emitting diode of claim 10, wherein the dopant within the emission layer of the organic light-emitting diode comprises an organic metal compound containing a transition metal.

13. The organic light-emitting diode of claim 12, wherein the emission layer of the organic light-emitting diode comprises at least one polycyclic compound represented by the following Chemical Formula 2 that is used in mixture with the organometallic compound containing a transition metal or by stacking the polycyclic compound on an upper or lower surface of a layer containing the organometallic compound: 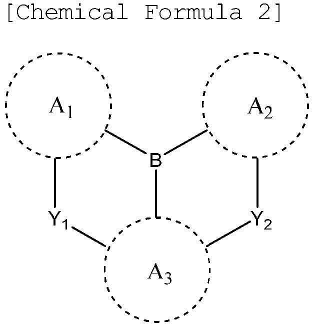 wherein,
Y₁ and Y₂, which are same or different, are each independently any one selected from O, S, NR₁₁, CR₁₂R₁₃, SiR₁₄R₁₅, and GeR₁₆R₁₇, A₁ to A₃, which are same or different, are each independently any one selected from a substituted or unsubstituted aromatic hydrocarbon ring of 6 to 50 carbon atoms, a substituted or unsubstituted aliphatic hydrocarbon ring of 5 to 50 carbon atoms, a substituted or unsubstituted, aliphatic hydrocarbon ring-fused aromatic hydrocarbon ring of 8 to 50 carbon atoms, a substituted or unsubstituted heteroaromatic ring of 2 to 50 carbon atoms, and a substituted or unsubstituted, aliphatic hydrocarbon ring-fused heteroaromatic ring of 5 to 50 carbon atoms,
R₁₁ to R₁₇, which are same or different, are each independently any one selected from a hydrogen atom, a deuterium atom, a tritium atom, a substituted or unsubstituted alkyl of 1 to 30 carbon atoms, a substituted or unsubstituted halogenated alkyl of 1 to 30 carbon atoms, a substituted or unsubstituted alkenyl of 2 to 30 carbon atoms, a substituted or unsubstituted alkynyl of 2 to 30 carbon atoms, a substituted or unsubstituted aryl of 6 to 50 carbon atoms, a substituted or unsubstituted cycloalkyl of 3 to 30 carbon atoms, a substituted or unsubstituted cycloalkenyl of 5 to 30 carbon atoms, a substituted or unsubstituted heterocycloalkyl of 2 to 30 carbon atoms, a substituted or unsubstituted heteroalkyl of 2 to 50 carbon atoms, a substituted or unsubstituted heteroaryl of 2 to 50 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted alkoxy of 1 to 30 carbon atoms, a substituted or unsubstituted aryloxy of 6 to 30 carbon atoms, a substituted or unsubstituted cycloalkyloxy of 3 to 30 carbon atoms, a substituted or unsubstituted heteroaryloxy of 2 to 30 carbon atoms, a substituted or unsubstituted alkylthio of 1 to 30 carbon atoms, a substituted or unsubstituted arylthio of 6 to 30 carbon atoms, a substituted or unsubstituted cycloalkylthio of 3 to 30 carbon atoms, a substituted or unsubstituted heteroarylthio of 2 to 30 carbon atoms, a substituted or unsubstituted amine of 0 to 40 carbon atoms, a substituted or unsubstituted silyl of 0 to 40 carbon atoms, a germanium of 0 to 40 carbon atoms, a nitro, a cyano, and a halogen,
R₁₁ to R₁₇ may be connected to the A₁ to A₃ ring moieties to additionally form an aliphatic or aromatic mono-or polycyclic ring, and
a linkage may be made between R₁₂ and R₁₃, between R₁₄ and R₁₅, and between R₁₆ and R₁₇ to additionally form respective mono-or polycyclic aliphatic or aromatic rings,
wherein the term "substituted" in the expression "substituted or unsubstituted" used for the compound of Chemical Formula 2 means having at least one substituent selected from the group consisting of a deuterium atom, a tritium atom, a cyano, a halogen, a hydroxy, a nitro, alkyl of 1 to 30 carbon atoms, a halogenated alkyl of 1 to 30 carbon atoms, an alkenyl of 2 to 24 carbon atoms, an alkynyl of 2 to 24 carbon atoms, a cycloalkyl of 3 to 24 carbon atoms, a heteroalkyl of 1 to 24 carbon atoms, an aryl of 6 to 24 carbon atoms, an arylalkyl of 7 to 24 carbon atoms, an alkylaryl of 7 to 24 carbon atoms, a heteroaryl of 2 to 24 carbon atoms, a heteroarylalkyl of 3 to 24 carbon atoms, an alkylheteroaryl of 3 to 24 carbon atoms, an alkoxy of 1 to 24 carbon atoms, an aromatic hydrocarbon ring-fused cycloalkyl of 7 to 30 carbon atoms, a heteroaromatic ring-fused cycloalkyl of 5 to 30 carbon atoms, an aromatic hydrocarbon ring-fused heterocycloalkyl of 6 to 30 carbon atoms, an aliphatic hydrocarbon ring-fused aryl of 7 to 30 carbon atoms, an aliphatic hydrocarbon ring-fused heteroaryl of 5 to 30 carbon atoms, a substituted or unsubstituted heteroaliphatic ring-fused aryl of 6 to 30 carbon atoms, a substituted or unsubstituted heteroaliphatic ring-fused heteroaryl of 5 to 30 carbon atoms, an amine of 1 to 30 carbon atoms, a silyl of 1 to 30 carbon atoms, a germanium of 1 to 30 carbon atoms, an aryloxy of 6 to 24 carbon atoms, and an arylthionyl of 6 to 24 carbon atoms, with at least one hydrogen atom on the substituents being substitutable with a deuterium or tritium atom.

14. An organic light-emitting diode of claim 13,
Wherein A₁ to A₃ are same or different and are each independently any one selected from a substituted or unsubstituted aromatic hydrocarbon ring of 6 to 30 carbon atoms and a substituted or unsubstituted aliphatic hydrocarbon ring-fused aromatic hydrocarbon ring of 8 to 50 carbon atoms.

15. The organic light-emitting diode of claim 11, wherein the organic light-emitting diode is used in any one selected from flat display devices, flexible display devices, monochrome or grayscale flat illumination devices, monochrome or grayscale flexible illumination devices, vehicle or aircraft display devices, and display devices for virtual or augmented reality.
